(19) Europäisches Patentamt / European Patent Office / Office européen des brevets

(11) **EP 3 451 132 A1**

(12) **EUROPEAN PATENT APPLICATION**
published in accordance with Art. 153(4) EPC

(43) Date of publication:
**06.03.2019 Bulletin 2019/10**

(51) Int Cl.:
*G06F 3/041* (2006.01)  *G06F 3/044* (2006.01)
*H05K 1/02* (2006.01)

(21) Application number: **17789518.2**

(22) Date of filing: **25.04.2017**

(86) International application number:
**PCT/JP2017/016351**

(87) International publication number:
**WO 2017/188236 (02.11.2017 Gazette 2017/44)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **26.04.2016 JP 2016087634**

(71) Applicant: **Fujikura Ltd.**
**Tokyo 135-8512 (JP)**

(72) Inventor: **OGURA, Shingo**
**Sakura-shi**
**Chiba 285-8550 (JP)**

(74) Representative: **Ter Meer Steinmeister & Partner**
**Patentanwälte mbB**
**Artur-Ladebeck-Strasse 51**
**33617 Bielefeld (DE)**

(54) **WIRING BODY, WIRING BODY ASSEMBLY, WIRING SUBSTRATE, AND TOUCH SENSOR**

(57) A first wiring body (5) includes a first resin portion (6) and a first conductor portion (7) provided on the first resin portion. The first conductor portion includes: a first lead wire (72) which has a mesh shape including first conductor wires (721), and a first terminal (73) which is electrically connected to the first lead wire and has a mesh shape including second conductor wires (731). The first conductor wires (721) intersect with each other to form first meshes (725) in a plan view. The second conductor wires (731) intersect with each other to form second meshes (735) in a plan view. An Expression (1) $S_2 \leq S_1$ is satisfied, where $S_1$ denotes a diameter of a first virtual circle (726) inscribed in the first mesh, and $S_2$ denotes a diameter of a second virtual circle (736) inscribed in the second mesh.

FIG. 6

**Description**

TECHNICAL FIELD

The present invention relates to a wiring body, a wiring body assembly, a wiring board, and a touch sensor.
For designated countries that are permitted to be incorporated by reference in the literature, the contents of Patent Application No. 2016-087634, filed with Japan Patent Office on April 26, 2016 is incorporated herein by reference and is regarded as a part of the description of this specification.

BACKGROUND ART

It is known that a touch window includes a sensing electrode, a wire electrically connected to the sensing electrode and an electrode pad arranged at one end of the wire and the electrode pad has a repetitive emboss pattern (for example, see Patent Document 1).

CITATION LIST

PATENT DOCUMENT

Patent Document 1: WO 2015/008934 A

SUMMARY OF THE INVENTION

PROBLEM TO BE SOLVED BY THE INVENTION

When the touch window is connected to a connection wiring body such as a flexible printed circuit (FPC), it is necessary to secure mechanical and electrical connection between the electrode pad of the touch window and a connection terminal of the connection wiring body by making close contact therebetween. However, it is difficult to sufficiently secure close contact between the wiring body and the connection wiring body merely by making the electrode pad an embossed pattern as in the touch window discussed in Patent Document 1. In addition, it is difficult to maintain mechanical and electrical connection between the electrode pad of the touch window and the connection terminal of the connection wiring body. Therefore, connection reliability between the touch window and the connection wiring body may be degraded.
An object of the invention is to provide a wiring body, a wiring body assembly, a wiring board, and a touch sensor capable of preventing a break of the lead wire and improving connection reliability of the terminal portion.

MEANS FOR SOLVING PROBLEM

[1] A wiring body according to the present invention is a wiring body including: a resin portion; and a conductor portion provided on the resin portion, in which the conductor portion includes a lead wire which has a mesh shape including first conductor wires, and a first terminal which is electrically connected to the lead wire and has a mesh shape including second conductor wires, the first conductor wires intersect with each other to form first meshes in a plan view, the second conductor wires intersect with each other to form second meshes in a plan view, and a following Expression (1) is satisfied:

$$S_2 \leq S_1 \ldots (1)$$

where, in the Expression (1), $S_1$ denotes a diameter of a first virtual circle inscribed in the first mesh, and $S_2$ denotes a diameter of a second virtual circle inscribed in the second mesh.
[2] In the wiring body described above, a following Expression (2) is satisfied:

$$W_2 \leq W_1 \ldots (2),$$

where, in the Expression (2), $W_1$ denotes a width of the first conductor wire, $W_2$ denotes a width of the second conductor wire, and the case where $S_1 = S_2$ and $W_1 = W_2$ is excluded.

[3] In the wiring body described above, a following Expression (3) may be satisfied:

$$W_2/S_2 \leq W_1/S_1 \ \dots \ (3).$$

[4] In the wiring body described above, a following Expression (4) may be satisfied:

$$A_2 \leq A_1 \ \dots \ (4)$$

where, in the Expression (4), $A_1$ denotes a ratio of an area of the lead wire occupied by the first conductor wire, and $A_2$ denotes a ratio of an area of the first terminal occupied by the second conductor wire.

[5] In the wiring body described above, the conductor portion further may include an electrode which is electrically connected to the lead wire and has a mesh shape including third conductor wires, the third conductor wires may intersect with each other to form third meshes in a plan view, and a following Expression (5) may be satisfied:

$$S_1 < S_3 \ \dots \ (5)$$

where, in the Expression (5), $S_3$ denotes a diameter of a third virtual circle inscribed in the third mesh.

[6] In the wiring body described above, a following Expression (6) may be satisfied:

$$W_3 < W_2 \ \dots \ (6)$$

where, in the Expression (6), $W_3$ denotes a width of the third conductor wire.

[7] In the wiring body described above, a following Expression (7) may be satisfied:

$$W_3/S_3 < W_2/S_2 \ \dots \ (7).$$

[8] In the wiring body described above, a following Expression (8) may be satisfied:

$$A_3 < A_2 \ \dots \ (8),$$

where, in the Expression (8), $A_3$ denotes a ratio of an area of the electrode occupied by the third conductor wire.

[9] In the wiring body described above, the conductor portion may further include a boundary portion which is interposed between the lead wire and the first terminal and electrically connect the lead wire and the first terminal.

[10] A wiring body assembly is a wiring body assembly including: the above-described wiring body; a connection wiring body which includes a substrate and a second terminal provided on the substrate to face the first terminal; and a conductive bonding portion provided between the first and second terminals to bond the first and second terminals.

[11] In the wiring body assembly described above, the conductive bonding portion may include a resin material and a terminal conductive particle dispersed in the resin material, and a following Expression (9) may be satisfied:

$$S_2 < D \ \dots \ (9),$$

where, in the Expression (9), D denotes a diameter of the terminal conductive particle.

[12] A wiring board according to the present invention is a wiring board including: the above-described wiring body or the above-described wiring body assembly; and a support body which supports the wiring body or the wiring body assembly.

[13] A touch sensor according to the present invention is a touch sensor including the above-described wiring board.

EFFECT OF THE INVENTION

According to the invention, the gap of the mesh of the lead wire is larger than the gap of the mesh of the terminal portion. As a result, the flexibility of the lead wire to expansion is improved, and it is possible to prevent disconnection of the lead wire. In addition, since the terminal portion is densely formed, it is possible to improve connection reliability of the terminal portion by virtue of an anchor effect of the terminal portion.

BRIEF DESCRIPTION OF DRAWINGS

Fig. 1 is a plan view showing a touch sensor in an embodiment of the invention;
Fig. 2 is an exploded perspective view showing the touch sensor;
Fig. 3 is a cross-sectional view taken along the line III-III of Fig. 1;
Fig. 4 is a plan view showing a first wiring body in an embodiment of the invention;
Fig. 5 is a partially enlarged view illustrating a part V of Fig. 4;
Fig. 6 is a partially enlarged view illustrating a part VI of Fig. 4;
Fig. 7 is a diagram for illustrating a ratio of the area occupied by a conductor wire;
Fig. 8 is a cross-sectional view taken along the line VIII-VIII of Fig. 5;
Fig. 9 is a cross-sectional view for illustrating a first conductor wire in an embodiment of the invention;
Figs. 10(A) to 10(E) are cross-sectional views (part 1) for illustrating a method of manufacturing a wiring board in an embodiment of the invention;
Figs. 11(A) to 11(E) are cross-sectional views (part 2) for illustrating a method of manufacturing a wiring board in an embodiment of the invention;
Fig. 12 is a cross-sectional view (part 3) for illustrating a method of manufacturing a wiring board in an embodiment of the invention; and
Fig. 13 is a cross-sectional view (part 4) for illustrating a method of manufacturing a wiring board in an embodiment of the invention.

MODE(S) FOR CARRYING OUT THE INVENTION

Embodiments of the invention will now be described with reference to the accompanying drawings.

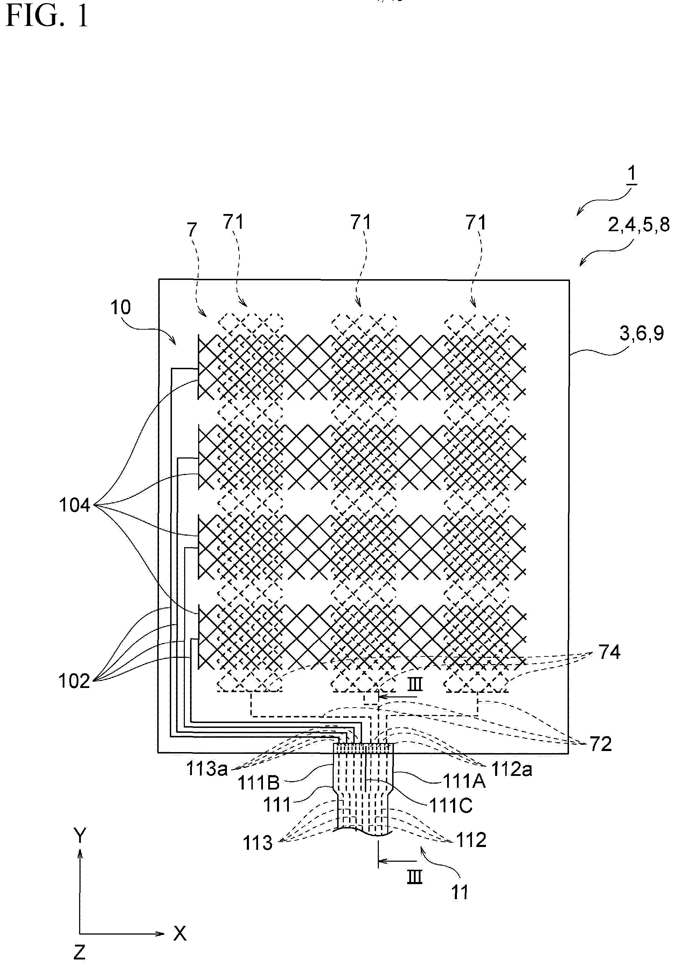

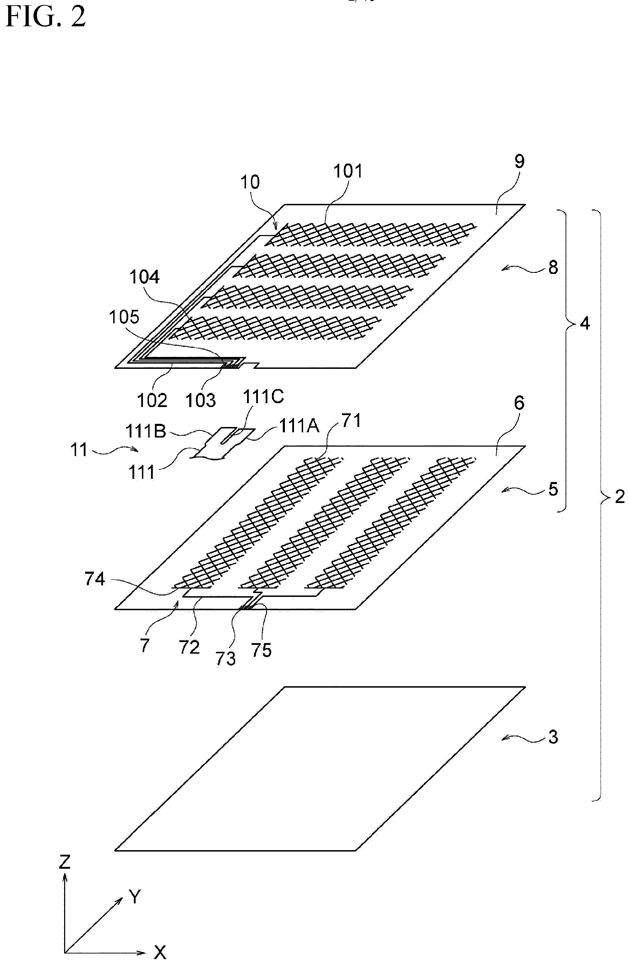

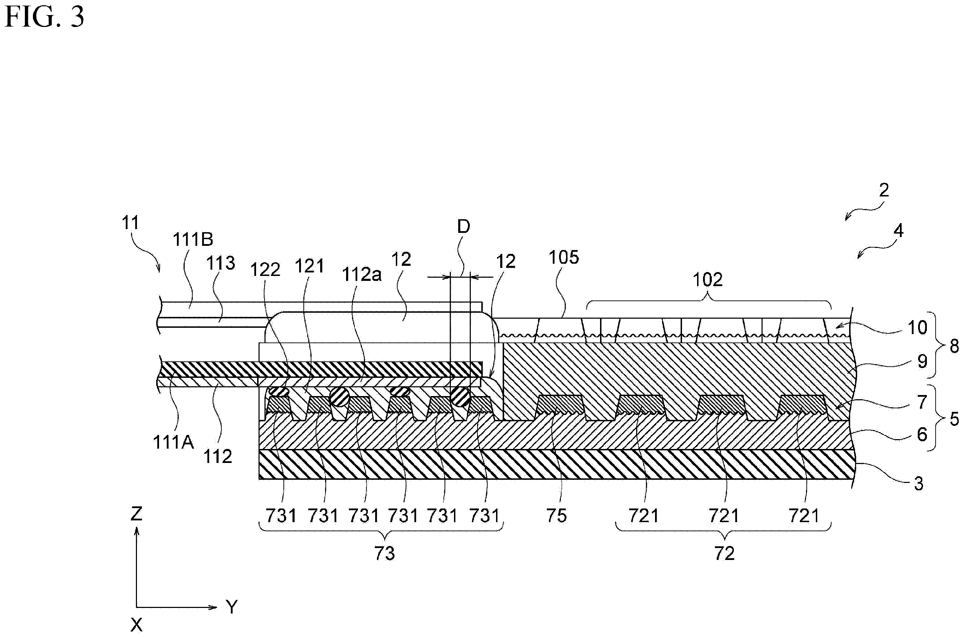

Fig. 1 is a plan view showing a touch sensor in an embodiment of the invention, and Fig. 2 is an exploded perspective view showing the touch sensor. Fig. 3 is a cross-sectional view taken along the line III-III of Fig. 1.
As illustrated in Fig. 1, a touch sensor 1 including a wiring board 2 of the embodiment is a projection electrostatic capacitance type touch panel sensor, and for example, is used as an input device having a function of detecting a touch position by being combination with a display device (not illustrated) or the like. Although not particularly limited, a liquid crystal display, an organic EL display, an electronic paper or the like can be used as the display device. In this touch sensor 1, a detection electrode and a driving electrode (first and second electrodes 71 and 101 described below) are disposed to overlap with an image to be projected onto the display device, and a predetermined voltage is periodically applied to between the two electrodes 71 and 101 from an external circuit (not illustrated).
In this touch sensor 1, for example, as an operator's finger (external conductor) approaches the touch sensor 1, a capacitance (electric capacity) is formed between the external conductor and the touch sensor 1, so that an electric state between the two electrodes changes. The touch sensor 1 can detect a touch position of the operator on the basis of an electric change between the two electrodes. The "touch sensor 1" of this embodiment corresponds to an example of a "touch sensor" of the invention, and the "wiring board 2" of this embodiment corresponds to an example of a "touch sensor" of the invention.
As illustrated in Figs. 1 and 2, this wiring board 2 includes a support body 3 and a wiring body assembly 4. The wiring body assembly 4 includes a first wiring body 5, a second wiring body 8 provided on the first wiring body 5, and a connection wiring body 11. The support body 3 and the first and second wiring bodies 5 and 8 in this embodiment are configured to have transparency (translucency) as a whole in order to secure visibility of the display device. The "wiring body assembly 4" of this embodiment corresponds to an example of a "wiring body assembly" of the invention. The "first wiring body 5" and the "second wiring body 8" of this embodiment correspond to an example of a "wiring body" of the invention. The "connection wiring body 11" of this embodiment corresponds to an example of a "connection wiring body" of the invention.
The support body 3 is a substrate having a transparent plate shape that allows transmission of visible light and supports the first wiring body 5. As a material of which the support body 3 is made, polyethylene terephthalate (PET), polyethylene naphthalate (PEN), polyimide resin (PI), polyetherimide resin (PEI), polycarbonate (PC), polyetheretherketone (PEEK), liquid crystal polymer (LCP), cycloolefin polymer (COP), silicon resin (SI), acrylic resin, phenolic resin, epoxy resin, glass and the like can be exemplified. This support body 3 may have an easily bondable layer or an optical adjustment layer. The "support body 3" of this embodiment corresponds to an example of a "support body" of the invention.

The first wiring body 5 includes a first resin portion 6 having a rectangular shape and a first conductor portion 7 provided on the first resin portion 6. The "first resin portion 6" of this embodiment corresponds to an example of a "resin portion" of the invention. The "first conductor portion 7" of this embodiment corresponds to an example of a "conductor portion" of the invention.

The first resin portion 6 is provided to hold the first conductor portion 7. The first resin portion 6 preferably has a thickness of, for example, 10 $\mu$m to 200 $\mu$m. The first resin portion 6 is formed of, for example, an insulating material such as UV-curable resin, thermosetting resin and thermoplastic resin such as epoxy resin, acrylic resin, polyester resin, urethane resin, vinyl resin, silicon resin, phenolic resin and polyimide resin.

The first conductor portion 7 includes a plurality of first electrodes 71, a plurality of first lead wires 72, a plurality of first terminals 73, a plurality of first boundary portions 74 and a plurality of second boundary portions 75. The first electrodes 71 and the first lead wires 72 are integrally formed on the first resin portion 6. In addition, the first lead wires 72 and the first terminals 73 are integrally formed on the first resin portion 6. That is, the first electrodes 71, the first lead wires 72, the first terminals 73, the first boundary portions 74 and the second boundary portions 75 are integrally formed. Herein, the "integral" means that the members are not separated from each other and are formed as an integral structure by the same material (containing conductive particles having the same particle diameter, binder resin and the like). The "first electrode 71" of this embodiment corresponds to an example of the "electrode" of the invention. The "first lead wire 72" of this embodiment corresponds to an example of the "lead wire" of the invention. The "first terminal 73" of this embodiment corresponds to an example of the "first terminal" of the invention. The "second boundary portion 75" of this embodiment corresponds to an example of the "boundary portion" of the invention.

Each of the first electrodes 71 extends in the Y-direction of the drawing, and a plurality of first electrodes 71 are juxtaposed in the X-direction of the drawing. The first lead wire 72 is electrically connected to one longitudinal direction end of each first electrode 71 through the first boundary portion 74. Each of the first lead wires 72 extends from one longitudinal direction end of each first electrode 71 to the vicinity of the outer edge of the first wiring body 5. The first terminal 73 is electrically connected to the other end of each of the first lead wires 72 through the second boundary portion 75. The first terminal 73 is electrically connected to the connection wiring body 11.

The number of the first electrodes 71 included in the first wiring body 5 is not particularly limited, and may be arbitrarily set. The number of the first lead wires 72 and the number of the first terminals 73 included in the first wiring body 5 are set depending on the number of the first electrodes 71.

Such a first conductor portion 7 contains binder resin and conductive particles (conductive powder) dispersed in the binder resin. The conductive particles may be formed of a metal material such as silver, copper, nickel, tin, bismuth, zinc, indium and palladium, or a carbon-based material such as graphite, carbon black (furnac black, acetylene black, Ketjen black), carbon nano-tube and carbon nano-fiber. Instead of the conductive particles, a metal salt which is a salt of the aforementioned metal material may be used.

As the conductive particles contained in the first conductor portion 7, for example, conductive particles having a particle diameter equal to or larger than 0.5 $\mu$m and equal to or smaller than 2 $\mu$m (0.5 $\mu$m $\leq$ $\varphi$ $\leq$ 2 $\mu$m) can be used depending on a width of the conductor wire included in the first conductor portion 7. In order to stabilize the electric resistance of the first conductor portion 7, it is preferable to use conductive particles having an average particle diameter $\varphi$ equal to or smaller than a half of the width of the conductor wire of the first conductor portion 7. It is preferable to use conductive particles having a specific surface area equal to or larger than 20 m$^2$/g when measured using a Brunauer-Emmett-Teller (BET) method.

When a relatively small electric resistance equal to or smaller than a predetermined value is obtained for the first conductor portion 7, it is preferable to use a metal material as the conductive particles. When a relatively large electric resistance value larger than a predetermined value is allowed for the first conductor portion 7, a carbon-based material may be used as the conductive particles. The carbon-based material is preferably used as the conductive particles in terms of improvement of haze and a total light reflectance of a mesh film.

Although described below in more details, in this embodiment, the first electrode 71 is formed in a mesh shape so that the first electrode 71 has light transparency. In this case, as the conductive material of the first electrode 71, a conductive material that has excellent conductivity but is opaque (opaque metal material and opaque carbon-based material) such as a metal material such as silver, copper and nickel, and the aforementioned carbon-based material may be employed.

As the binder resin, acrylic resin, polyester resin, epoxy resin, vinyl resin, urethane resin, phenolic resin, polyimide resin, silicon resin, fluororesin and the like can be exemplified. The binder resin may be omitted from the material of the first conductor portion 7.

The first conductor portion 7 is formed by applying and curing a conductive paste. As a specific example of the conductive paste, a conductive paste may be formed by mixing conductive particles, binder resin, water or a solvent, and various additives. As the solvent contained in the conductive paste, $\alpha$-terpineol, butyl carbitol acetate, butyl carbitol, 1-decanol, butyl cellosolve, diethylene glycol monoethyl ether acetate, tetradecane and the like can be exemplified.

As illustrated in Figs. 1 and 2, the second wiring body 8 has a second resin portion 9 having a rectangular shape and a second conductor portion 10 provided on the second resin portion 9. The second resin portion 9 is provided to cover the first conductor portion 7 and is interposed between the first and second conductor portions 7 and 10. In this embodiment, this second resin portion 9 serves as a dielectric body provided between a pair of electrodes 71 and 101 of the touch sensor 1. A detection sensitivity of the touch sensor 1 is adjusted by controlling a thickness of the second resin portion 9. The thickness of the second resin portion 9 is preferably, for example, 20 $\mu$m to 200 $\mu$m. A first terminal 73 is exposed from a notch provided at one side of the second resin portion 9. The second resin portion 9 is formed of the same material as that of the first resin portion 6.

The second conductor portion 10 has a plurality of second electrodes 101, a plurality of second lead wires 102, a plurality of second terminals 103, a plurality of third boundary portions 104 and a plurality of fourth boundary portions 105. The second electrode 101 and the second lead wire 102 are integrally formed on the second resin portion 9. In addition, the second lead wire 102 and the second terminal 103 are integrally formed on the second resin portion 9. That is, the second electrode 101, the second lead wire 102, the second terminal 103, the third boundary portion 104 and the fourth boundary portion 105 are integrally formed.

Each of the second electrodes 101 extends in the X-direction of the drawing, and a plurality of second electrodes 101 are juxtaposed in the Y-direction of the drawing. The second lead wire 102 is electrically connected to one longitudinal direction end of each second electrode 101 through the third boundary portion 104. Each of the second lead wires 102 extends from one longitudinal direction end of each second electrode 101 to the vicinity of the outer edge of the second wiring body 8. The second terminal 103 is electrically connected to the other end of each second lead wire 102 through the fourth boundary portion 105. The second terminal 103 is electrically connected to the connection wiring body 11.

The number of the second electrodes 101 provided in the second wiring body 8 is not particularly limited, and may be arbitrarily set. The number of the second lead wires 102 and the number of the second terminals 103 included in the second wiring body 8 are set depending on the number of the second electrodes 101. The "second electrode 101" of this embodiment corresponds to an example of the "electrode" of the invention. The "second lead wire 102" of this embodiment corresponds to an example of the "lead wire" of the invention. The "second terminal 103" of this embodiment corresponds to an example of the "first terminal" of invention. The "fourth boundary portion 105" of this embodiment corresponds to an example of the "boundary portion" of the invention.

As illustrated in Figs. 1 to 3, the connection wiring body 11 is a flexible printed circuit (FPC) and includes a substrate 111 and a plurality of wires 112 and 113 formed on a lower surface of the substrate 111. The substrate 111 may be formed of a film material such as polyethylene terephthalate (PET), polyethylene naphthalate (PEN), polyimide resin (PI) or polyetherimide resin (PEI). The "substrate 111" of this embodiment corresponds to an example of the "substrate" of the invention.

A slit 111C is formed at the width direction center of the one longitudinal direction end of the substrate 111, and the one longitudinal direction end of the substrate 111 is bisected by the slit 111C in the width direction. One-side ends of a plurality of wires 112 are arranged on the lower surface of the one side (first branch 111A) of the one longitudinal direction end of the substrate 111, and one-side ends of a plurality of wires 113 are arranged on the lower surface of the other side (second branch 111B) of the one longitudinal direction end of the substrate 111.

As illustrated in Fig. 1, a plurality of wires 112 are juxtaposed with each other. A connection terminal 112a is arranged at each tip of the plurality of wires 112 to correspond to a plurality of first terminals 73 of the first wiring body 5. A plurality of wires 113 are juxtaposed with each other. A connection terminal 113a is arranged at each tip of the plurality of wires 113 to correspond to the second terminal 103 of the second wiring body 8. The materials of the wires 112 and 113 or the connection terminals 112a and 113a are not particularly limited, and copper or the same material as that of the first conductor portion 7 may be used. The "connection terminal 112a" and the "connection terminal 113a" of this embodiment correspond to an example of the "second terminal" of the invention.

The connection wiring body 11 is not particularly limited to the flexible printed circuit (FPC), and other wiring boards such as a rigid board or a rigid flexible board may be employed.

The ends of the first branch 111A and areas of the first wiring body 5 exposed from the notch of the second resin portion 9 vertically face each other via the conductive bonding portion 12 and are bonded by the conductive bonding portion 12. The connection terminal 112a and the first terminal 73 vertically face each other via the conductive bonding portion 12.

The conductive bonding portion 12 has a function of electrically and mechanically connecting the connection terminal 112a and the first terminal 73 to each other. In addition, the conductive bonding portion 12 has a function of insulating the neighboring terminals. As the conductive bonding portion 12, an anisotropic conductive film (ACF), an anisotropic conductive paste (ACP) and the like can be exemplified.

The conductive bonding portion 12 is formed by dispersing a plurality of terminal conductive particles 122 into the resin material 121. Although four terminal conductive particles 122 dispersed into the resin material 121 are illustrated in Fig. 3, other terminal conductive particles 122 are dispersed into the resin material 121 in an actual conductive bonding portion 12. In order to improve connection reliability between the first wiring body 5 and the connection wiring body 11, a relationship between a diameter D of the terminal conductive particle 122 and a diameter $S_2$ of a second virtual circle 736 inscribed in the second mesh 735 of the first terminal 73 described below preferably satisfies the following Expression (10) and more preferably satisfies the following Expression (11).

$$S_2 < D \ ... \ (10)$$

$$S_2 \approx D \times 2/3 \ ... \ (11)$$

As the terminal conductive particle 122, a conductive particle having a diameter D of 3 $\mu$m to 20 $\mu$m can be used. For example, a product number CP6920F3 (having a diameter of 3 $\mu$m) or a product number CP923CM-25 AC (having a diameter of 20 $\mu$m) produced by Dexerials Corporation can be used.

The connection terminal 112a and the first terminal 73 may be electrically and mechanically connected to each other using a metal paste such as a silver paste and a solder paste instead of the anisotropic conductive material. In this case, it is necessary to form a plurality of bonding portions at intervals in order to insulate the neighboring terminals.

The end of the second branch 111B and a vicinity area of one side of the second wiring body 8 vertically face each other via the conductive bonding portion 12 and are bonded to each other by the conductive bonding portion 12 described above. The connection terminal 113a and the second terminal 103 vertically face each other via the conductive bonding portion 12 and are electrically and mechanically connected to each other by the conductive bonding portion 12.

The "conductive bonding portion 12" of this embodiment corresponds to an example of the "conductive bonding portion" of the invention, and the "resin material 121" of this embodiment corresponds to an example of the "resin material" of the invention. The "terminal conductive particle 122" of this embodiment corresponds to an example of the "conductive particle" of the invention.

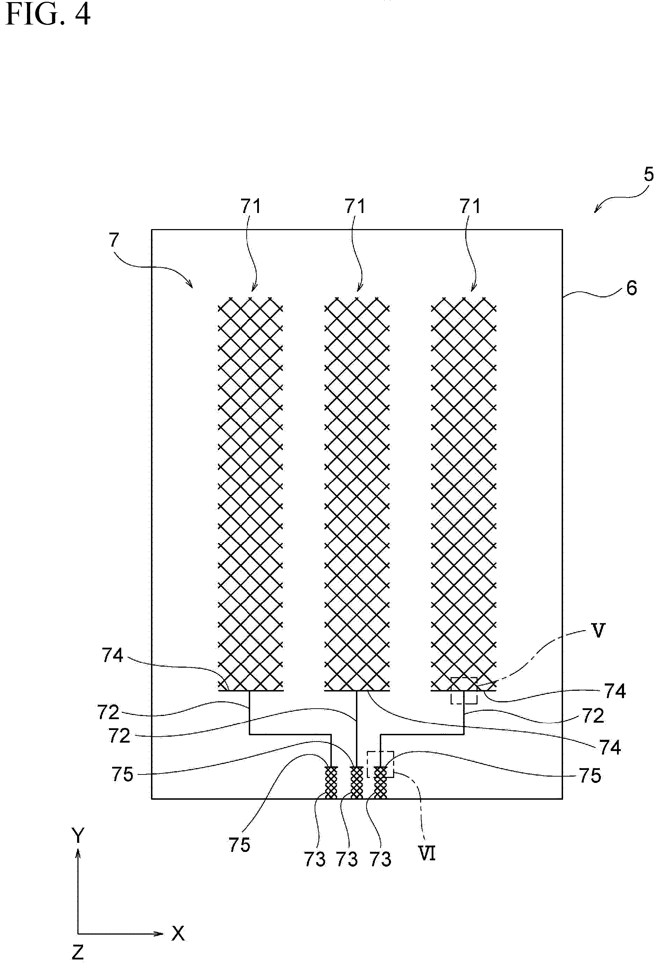

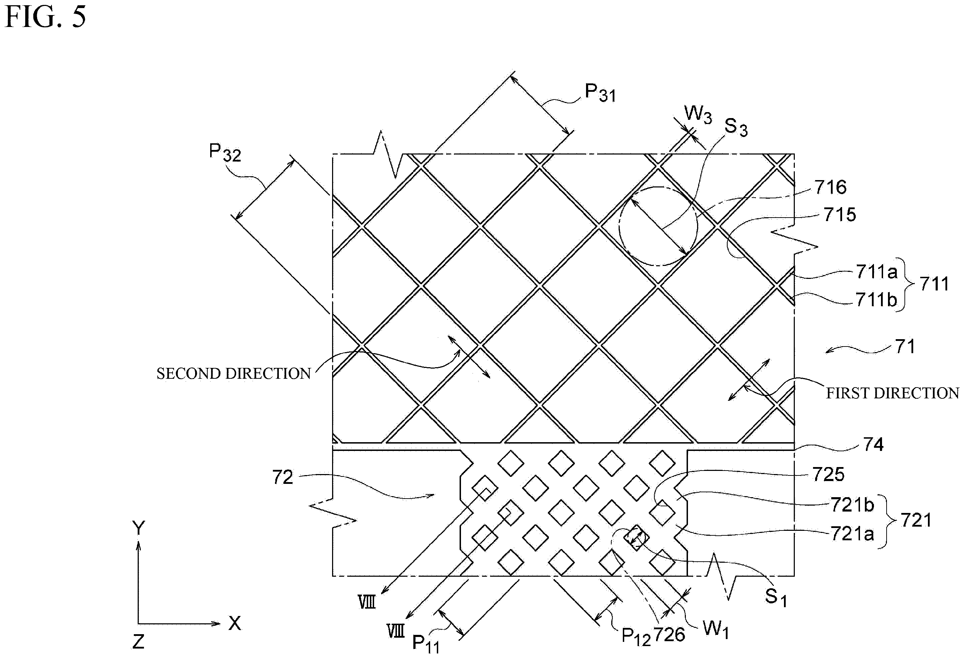

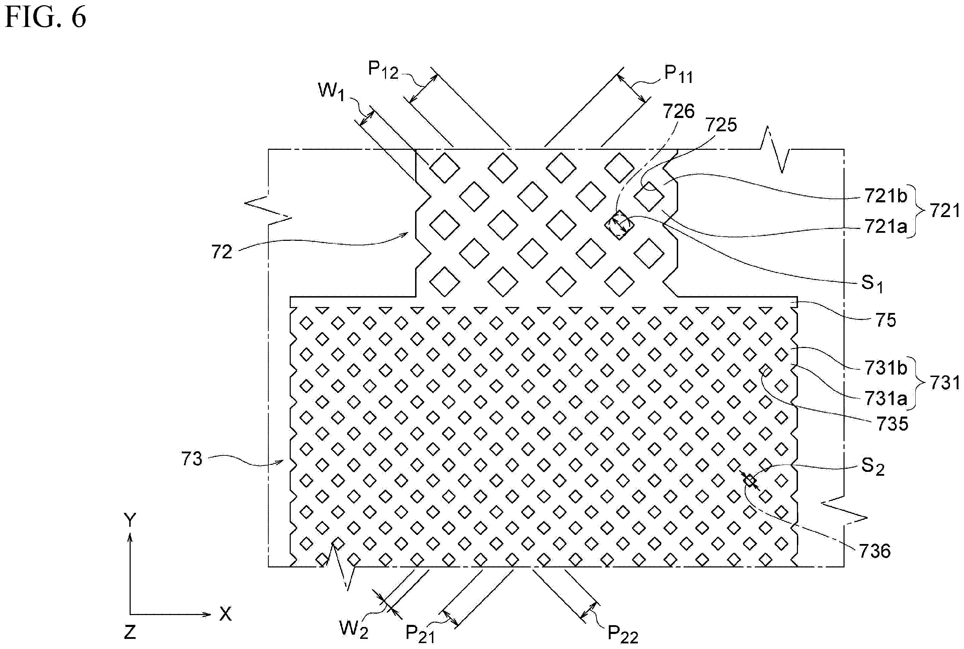

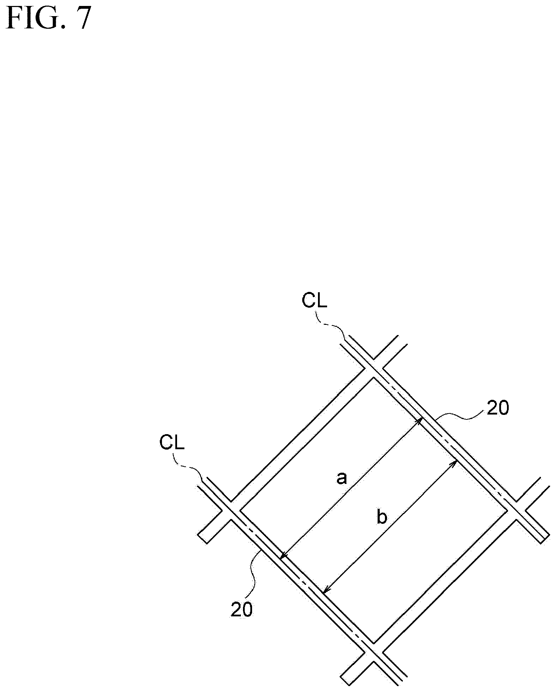

Fig. 4 is a plan view showing the first wiring body in an embodiment of the invention. Fig. 5 is a partially enlarged view illustrating a portion V of Fig. 4, and Fig. 6 is a partially enlarged view illustrating a portion VI of Fig. 4. Fig. 7 is a diagram for illustrating a ratio of the area occupied by the conductor wire. In the first wiring body 5 of this embodiment shown in Fig. 4, the first electrode 71 has a mesh shape formed of a plurality of straight third conductor wires 711. Specifically, as illustrated in Fig. 5, a plurality of third conductor wires 711a each extending in a direction (hereinafter, referred to as a "first direction") inclined by an angle of +45° with respect to the X-direction are arranged side by side at equal pitches $P_{31}$ in a direction (hereinafter, referred to as a "second direction") substantially perpendicular to the first direction, and a plurality of third conductor wires 711b each extending in the second direction are arranged side by side at equal pitches $P_{32}$ in the first direction. Since the third conductor wires 711a and 711b are perpendicular to each other, the first electrode 71 is formed to have a mesh shape in which third meshes 715 each having a quadrilateral shape (having a rhombic shape) are repeatedly arranged. The third conductor wire 711 means both the third conductor wires 711a and 711b.

In this embodiment, the pitch $P_{31}$ is substantially equal to the pitch $P_{32}$ ($P_{31} = P_{32}$). However not particularly limited to this, the pitch $P_{31}$ may be different from the pitch $P_{32}$ ($P_{31} \neq P_{32}$).

As seen in a plan view, a third virtual circle 716 is inscribed in the third mesh 715 of the first electrode 71. A diameter $S_3$ of the third virtual circle 716 (diameter $S_3$ of the third virtual circle 716) is preferably set to a range of 90 $\mu$m to 500 $\mu$m and is preferably equal to or smaller than 250 $\mu$m.

Herein, the virtual circle inscribed in the mesh means a maximum virtual perfect circle inscribed in the mesh as seen in the plan view. In this embodiment, the virtual circle inscribed in the mesh is a virtual perfect circuit inscribed in each side of the mesh having a quadrilateral shape as seen in the plan view.

The shape of each third mesh 715 included in the mesh shape of the first electrode 71 is not particularly limited to those described above. For example, each third mesh 715 may have a triangular shape such as an equilateral triangle, an isosceles triangle and a right angled triangle, or a quadrilateral shape such as a parallelogram and a trapezoid. The mesh shape may include an n-sided polygon such as a hexagon, an octagon, a dodecagon and an icosagon, a circle, an ellipse, a star or the like. In this manner, a geometric pattern obtained by repeating various graphic units can be used as a shape of each mesh of the first electrode 71.

The width $W_3$ (maximum width) of the third conductor wire 711 may be set to a range of 0.5 $\mu$m to 10 $\mu$m and is preferably equal to or smaller than 5 $\mu$m. The third conductor wire 711 preferably has a height of 0.5 $\mu$m to 10 $\mu$m.

Herein, the width of the conductor wire corresponds to an interval between the neighboring meshes in a direction perpendicular to the extending direction of the conductor wire.

In the first electrode 71, in order to improve visibility of the touch sensor 1, a ratio ($W_3/S_3$) between the width

$W_3$ and the diameter $S_3$ may be set to a range of 0.001 to 0.12, and is preferably 0.002 to 0.055. In order to improve visibility of the touch sensor 1, a ratio of the area of the first electrode 71 occupied by the third conductor wire 711 may be set to a range of 0.19% to 19%, and is preferably 0.39% to 10.2%.

The "ratio of the area of the mesh shape occupied by the conductor wire" is the ratio expressed by the following Expression (12) (refer to Fig. 7).

$$(\text{ratio of area occupied by conductor wire}) = \{(a \times a) - (b \times b)\}/(a \times a) \ldots (12)$$

Here, in Expression (12), "a" denotes a pitch between an arbitrary conductor wire 20 and another conductor wire 20 neighboring to this conductor wire 20 (distance between the center lines CL), and "b" denotes a distance between an arbitrary conductor wire 20 and another conductor wire 20 neighboring to this conductor wire 20.

The "third conductor wire 711" of this embodiment corresponds to an example of the "third conductor wire" of the invention. The "third mesh 715" of this embodiment corresponds to an example of the "third mesh" of the invention. The "third virtual circle 716" of this embodiment corresponds to an example of the "third virtual circle" of the invention.

Returning to Fig. 4, the first lead wire 72 has a mesh shape formed of first conductor wires 721 having a straight shape. Specifically, as illustrated in Fig. 5, a plurality of first conductor wires 721a each extending in the first direction are arranged side by side at equal pitches $P_{11}$ in the second direction, and a plurality of first conductor wires 721b each extending in the second direction are arranged side by side at equal pitches $P_{12}$ in the first direction. Since the first conductor wires 721a and 721b perpendicularly intersect with each other, the first lead wire 72 is formed to have a mesh shape in which the first mesh 725 each having a quadrilateral shape (rhombic shape) are repeatedly arranged. The first conductor wire 721 means both the first conductor wires 721a and 721b.

In this embodiment, the pitch $P_{11}$ is substantially equal to the pitch $P_{12}$ ($P_{11} = P_{12}$). However not particularly limited to this, the pitches $P_{11}$ and $P_{12}$ may be different values ($P_{11} \neq P_{12}$). The shape of the first mesh 725 may be a geometric pattern obtained by repeating various graphic units, similar to the shape of the third mesh 715.

Although a plurality of first meshes 725 are arranged regularly across the entire first lead wire 72 in this embodiment, it is not limited thereto. For example, there may be a portion where a plurality of first meshes 725 are not regularly arranged in a part of the first lead wire 72. For example, in Figs. 5 and 6, as the first mesh 725, an empty portion having the shape obtained by bisecting the quadrilateral shape along the extending direction of the first lead wire 72 is at the width direction end of the first lead wire 72. However, this empty portion may be buried with a conductor portion.

The first virtual circle 726 is inscribed in the first mesh 725 of the first lead wire 72 as seen in the plan view. In this embodiment, in order to improve visibility of the touch sensor 1, the diameter $S_1$ of the first virtual circle 726 and the diameter $S_3$ of the third virtual circle 716 inscribed in the third mesh 715 of the first electrode 71 preferably satisfy a relationship expressed in the following Expression (13).

$$S_1 < S_3 \ldots (13)$$

The diameter $S_1$ of the first virtual circle 726 may be set to a range of 3 $\mu$m to 50 $\mu$m, and is preferably equal to or smaller than 10 $\mu$m.

The width $W_1$ (maximum width) of the first conductor wire 721 may be set to a range of 5 to 200 $\mu$m, and is preferably equal to or larger than 10 $\mu$m. The first conductor wire 721 preferably has a height of 0.5 $\mu$m to 20 $\mu$m.

In the first lead wire 72, in order to improve detection sensitivity of the touch sensor by improving conductivity, the ratio ($W_1/S_1$) between the width $W_1$ and the diameter $S_1$ may be set to a range of 0.10 to 66, and is preferably a range of 1 to 66. The ratio $A_1$ of the area of the first lead wire 72 occupied by the first conductor wire 721 may be set to a range of 17% to 99.9%, and is preferably 75% to 99.9%.

The "first conductor wire 721" of this embodiment corresponds to an example of the "first conductor wire" of the invention, and the "first mesh 725" of this embodiment corresponds to an example of the "first mesh" of the invention. The "first virtual circle 726" of this embodiment corresponds to an example of the "first virtual circle" of the invention.

The first boundary portion 74 interposed between the first electrode 71 and the first lead wire 72 is formed of a single conductor wire having a straight line shape. The first boundary portion 74 is provided to securely connect the first electrode 71 and the first lead wire 72 when the mesh shape of the first electrode 71 is different from the mesh shape of the first lead wire 72. The longitudinal direction length of the first boundary portion 74 (the X-direction of the drawing in this embodiment) is equal to or larger than the width of the first lead wire 72 and equal to or smaller than the width of the first electrode 71. The first boundary portion 74 is connected to the third conductor wire 711 positioned at one longitudinal direction end of the first electrode 71 and is connected to the first conductor wire 721 positioned at one end of the first lead wire 72. The width of the first boundary portion 74 is preferably 10 $\mu$m to 100 $\mu$m. The first boundary

portion 74 is not limited to the conductor wire having a straight shape, but a conductor wire having a curved shape may be employed.

As illustrated in Figs. 4 and 6, the first terminal 73 has a mesh shape formed of a plurality of second conductor wires 731 having a straight shape. Specifically, a plurality of second conductor wires 731a each extending in the first direction are arranged side by side at equal pitches $P_{21}$ in the second direction, and a plurality of second conductor wires 731b each extending in the second direction are arranged side by side at equal pitches $P_{22}$ in the first direction. Since the second conductor wires 731a and 731b perpendicularly intersect with each other, the first terminal 73 is formed to have a mesh shape in which the second meshes 735 each having a quadrilateral shape (rhombic shape) are repeatedly arranged. The second conductor wire 731 means both the second conductor wires 731a and 731b.

In this embodiment, the pitches $P_{21}$ and $P_{22}$ are substantially equal to each other ($P_{21} = P_{22}$). However not particularly limited to this, the pitches $P_{21}$ and $P_{22}$ may be different from each other ($P_{21} \neq P_{22}$). The shape of the second mesh 735 may be a geometric pattern obtained by repeating various graphic units, similar to the shape of the third mesh 715.

Although a plurality of second meshes 735 are regularly arranged across the entire first terminal 73 in this embodiment, it is not limited thereto. For example, there may be a portion where a plurality of second meshes 735 are not regularly arranged in a part of the first terminal 73. For example, in Fig. 6, as the second mesh 735, an empty portion having a shape obtained by bisecting the quadrilateral shape along the extending direction of the first terminal 73 is at the width direction end of the first terminal 73. However, this empty portion may be buried with a conductor portion.

The second virtual circle 736 is inscribed in the second mesh 735 of the first terminal 73 as seen in the plan view. In this embodiment, in order to improve adherence between the first wiring body 5 and the connection wiring body 11, a relationship between the diameter $S_2$ of the second virtual circle 736 and the diameter $S_1$ of the first virtual circle 726 inscribed in the first mesh 725 of the first lead wire 72 satisfies the following Expression (14).

$$S_2 \leq S_1 \ \dots \ (14)$$

Such a diameter $S_2$ may be set to a range of 3 $\mu$m to 30 $\mu$m, and is preferably equal to or smaller than 10 $\mu$m.

In order to improve adherence between the first wiring body 5 and the connection wiring body 11, a relationship between the width $W_2$ of the second conductor wire 731 and the width $W_1$ of the first conductor wire 721 of the first lead wire 72 preferably satisfies the following Expression (15). However, a case where "$S_1 = S_2$" in the aforementioned Expression (14) and "$W_1 = W_2$" in the following Expression (15) is excluded.

$$W_2 \leq W_1 \ \dots \ (15)$$

In order to improve visibility of the touch sensor 1, a relationship between the width $W_2$ of the second conductor wire 731 and the width $W_3$ of the third conductor wire of the first electrode 71 preferably satisfies the following Expression (16).

$$W_3 < W_2 \ \dots \ (16)$$

The width $W_2$ (maximum width) of the second conductor wire 731 may be set to a range of 3 $\mu$m to 50 $\mu$m, and is preferably equal to or smaller than 10 $\mu$m. The second conductor wire 731 preferably has a height of 0.5 $\mu$m to 20 $\mu$m.

In order to improve adherence between the first wiring body 5 and the connection wiring body 11, a ratio ($W_2/S_2$) between the width $W_2$ and the diameter $S_2$ and a ratio ($W_1/S_2$) between the width $W_1$ and the diameter $S_1$ preferably has a relationship satisfying the following Expression (17).

$$W_2/S_2 \leq W_1/S_1 \ \dots \ (17)$$

In order to improve visibility of the touch sensor, the ratio $W_2/S_2$ between the width $W_2$ and the diameter $S_2$ and the ratio $W_3/S_3$ between the width $W_3$ and the diameter $S_3$ preferably satisfy a relationship expressed in the following Expression (18).

$$W_3/S_3 < W_2/S_2 \ \dots \ (18)$$

In the first terminal 73, the ratio $W_2/S_2$ between the width $W_2$ and the diameter $S_2$ may be set to a range of 0.10 to 17, and is preferably 0.3 to 3.4. When the conductive bonding portion 12 is used, the ratio $W_2/S_2$ between the width $W_2$ and the diameter $S_2$ is preferably equal to or smaller than 0.5 in order to improve connection reliability between the first wiring body 5 and the connection wiring body 11 by effectively holding the terminal conductive particles 122 between the first terminal 73 and the connection terminal 112a. The ratio $W_2/S_2$ between the width $W_2$ and the diameter $S_2$ is preferably equal to or smaller than 1 in order to improve connection reliability between the first wiring body 5 and the connection wiring body 11 by increasing a contact area between the first terminal 73 and the connection terminal 112a via the conductive bonding portion 12.

In order to improve adherence between the first wiring body 5 and the connection wiring body 11, the ratio $A_2$ of the area of the first terminal 73 occupied by the second conductor wire 731 and the ratio $A_1$ of the area of the first lead wire 72 occupied by the first conductor wire 721 preferably have a relationship satisfying the following Expression (19).

$$A_2 \leq A_1 \ \ldots \ (19)$$

In order to improve visibility of the touch sensor 1, a relationship between the ratio $A_2$ and the ratio $A_3$ of the area of the first electrode 71 occupied by the third conductor wire 711 preferably satisfies the following Expression (20).

$$A_3 < A_2 \ \ldots \ (20)$$

This ratio $A_2$ may be set to a range of 17% to 99.6%, and is preferably 40% to 94.7%. When the conductive bonding portion 12 is used, the ratio $A_2$ is preferably equal to or smaller than 75% in order to improve connection reliability between the first wiring body 5 and the connection wiring body 11 by increasing a contact area between the first terminal 73 and the connection terminal 112a via the conductive bonding portion 12. In addition, the ratio $A_2$ is more preferably equal to or smaller than 56% in order to improve connection reliability between the first wiring body 5 and the connection wiring body 11 by effectively holding the terminal conductive particles 122 between the first terminal 73 and the connection terminal 112a. That is, the ratio $A_2$ is preferably 40% to 75%, and more preferably 40% to 56%.

The "second conductor wire 731" of this embodiment corresponds to an example of the "second conductor wire" of the invention. The "second mesh 735" of this embodiment corresponds to an example of the "second mesh" of the invention. The "second virtual circle 736" of this embodiment corresponds to an example of the "second virtual circle" of the invention.

The second boundary portion 75 interposed between the first lead wire 72 and the first terminal 73 is formed of a single conductor wire having a straight line shape. The second boundary portion 75 is provided to securely connect the first lead wire 72 and the first terminal 73 when the mesh shape of the first lead wire 72 is different from the mesh shape of the first terminal. The longitudinal direction length of the second boundary portion 75 (the X-direction of the drawing in this embodiment) is equal to or larger than the smaller one of the widths of the first lead wire 72 and the first terminal 73 (the width of the first lead wire 72 in this embodiment) and is equal to or smaller than the larger one of the widths of the first lead wire 72 and the first terminal 73 (the width of the first terminal 73 in this embodiment). The second boundary portion 75 is connected to the first conductor wire 721 positioned at the other end of the first lead wire 72 and is connected to the second conductor wire 731 positioned at one end of the first terminal 73. The width of the second boundary portion 75 is preferably 10 μm to 100 μm. The second boundary portion 75 is not limited to the conductor wire having a straight shape, but a conductor wire having a curved shape may be employed.

Similar to the first electrode 71, the second electrode 101 has a mesh shape formed of a plurality of straight conductor wires. Similar to the first lead wire 72, the second lead wire 102 has a mesh shape formed of a plurality of straight conductor wires. The third boundary portion 104 interposed between the second electrode 101 and the second lead wire 102 is formed of a single conductor wire. Similar to the first terminal 73, the second terminal 103 has a mesh shape formed of a plurality of straight conductor wires. The fourth boundary portion 105 interposed between the second lead wire 102 and the second terminal 103 is formed of a single conductor wire.

A basic structure of the second electrode is similar to that of the first electrode 71. A basic structure of the second lead wire 102 is similar to that of the first lead wire 72. A basic structure of the second terminal 103 is similar to that of the first terminal 73. A basic structure of the third boundary portion 104 is similar to that of the first boundary portion 74. A basic structure of the fourth boundary portion 105 is similar to that of the second boundary portion 75. Herein, the second electrode 101, the second lead wire 102, the second terminal 103, the third boundary portion 104 and the fourth boundary portion 105 will not be described in detail by referring the descriptions of the first electrode 71, the first lead wire 72, the first terminal 73, the first boundary portion 74 and the second boundary portion 75.

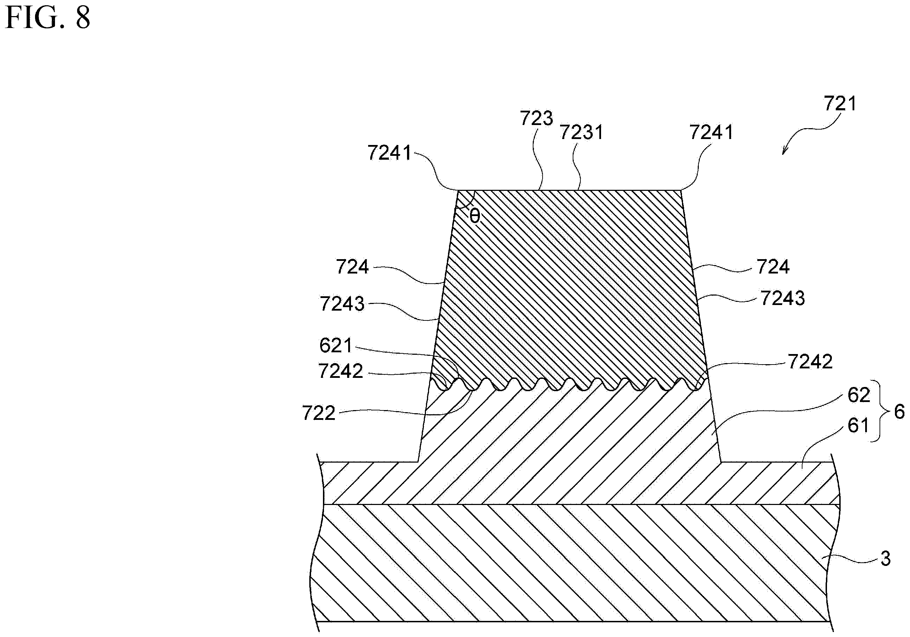

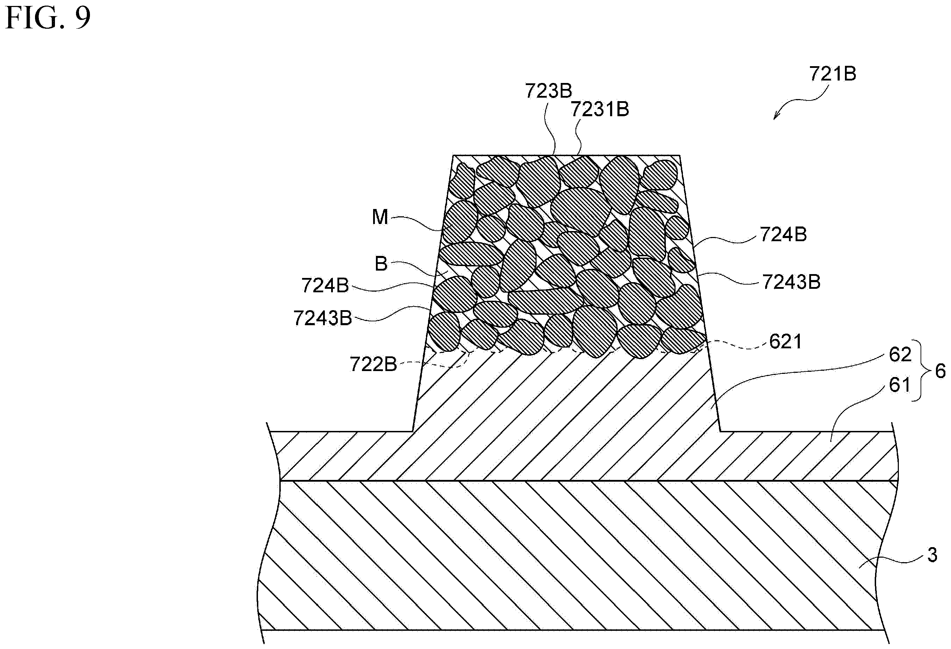

Fig. 8 is a cross-sectional view taken along the line VIII-VIII of Fig. 5. Fig. 9 is a cross-sectional view for illustrating the first conductor wire in an embodiment of the invention. In order to facilitate understanding of the first resin portion 6 and the first conductor portion 7 included in the first wiring body 5 of this embodiment, the structure of the second wiring body 8 is not shown in Figs. 8 and 9.

As illustrated in Fig. 8, when the first conductor wire 721 is seen in a cross-sectional view taken along the width direction, the first resin portion 6 has a flat portion 61 and a protruding portion 62. The flat portion 61 is a portion of the first resin portion 6 which is formed in the shape of a layer. The top surface of the flat portion 61 is flat.

The protruding portion 62 is provided on the first flat portion 51, protrudes from the flat portion 61 and is formed integrally with the flat portion 61. This protruding portion 62 is provided to correspond to the first conductor wire 721 and supports the first conductor wire 721.

The protruding portion 62 has a resin portion contact surface 621 contacting with the first conductor wire 721 (specifically, the conductor portion contact surface 722 (described below)). As illustrated in Fig. 8, this resin portion contact surface 621 has an uneven shape complementary to the conductor portion contact surface 722 having an uneven shape. Although not illustrated in particular, the resin portion contact surface 621 and the conductor portion contact surface 722 also have a mutually complementary unevenness shape in the extending direction cross section of the first conductor wire 721. In order to facilitate understanding of the first wiring body 5 in this embodiment, the uneven shapes of the resin portion contact surface 621 and the conductor portion contact surface 722 are exaggerated in Fig. 8.

When the first conductor wire 721 is seen in a cross-sectional view taken in the width direction, the first conductor wire 721 has the conductor portion contact surface 722, the conductor portion top surface 723 and the conductor portion side surface 724 as illustrated in Fig. 8.

The conductor portion contact surface 722 is a surface contacting with the resin portion contact surface 621. This conductor portion contact surface 722 has an uneven shape. This uneven shape is formed on the basis of plane roughness of the conductor portion contact surface 722. The plane roughness of the conductor portion contact surface 722 will be described below in more details.

The conductor portion top surface 723 is a surface opposite to the conductor portion contact surface 722 in the first conductor portion 7. The conductor portion top surface 723 of this embodiment includes a top surface flat portion 7231 having a straight shape. In the width direction cross section of the first conductor portion 7, the width of the top surface flat portion 7231 is equal to or larger than a half of the width of the conductor portion top surface 723. In this embodiment, the substantially entire conductor portion top surface 723 serves as the top surface flat portion 7231. The flatness of the top surface flat portion 7231 is equal to or smaller than 0.5 $\mu$m. The flatness may be defined according to the JIS standard (JIS B0621 (1984)).

The flatness of the top surface flat portion 7231 is obtained by a noncontact measurement method using laser light. Specifically, the flatness is measured by irradiating strip-like laser light to a measurement target and focusing its reflection light on an image device (for example, two-dimensional CMOS). The flatness is calculated by setting a plane passing through three points as separate as possible on a target plane and setting a maximum deflection value as the flatness (maximum deflection flatness). The method of measuring or calculating the flatness is not particularly limited to those described above. For example, the flatness may be measured using a contact type measurement method using a dial gauge or the like. As the flatness calculation method, a method of calculating a value of the gap obtainable when the target plane is interposed between parallel planes as the flatness (maximum slant flatness) may be used.

The conductor portion side surface 724 is interposed between the conductor portion contact surface 722 and the conductor portion top surface 723. The conductor portion side surface 724 is connected to the conductor portion top surface 723 at one end 7241 and is connected to the conductor portion contact surface 722 at the other end 7242. The conductor portion side surface 724 is continuously connected to the side surface of the protruding portion 62. In this embodiment, two conductor portion side surfaces 724 in one first conductor portion 7 are inclined to be close to the center of the first conductor wire 721 as being separated from the first resin portion 6. The first conductor wire 721 has a tapered shape in which the first conductor wire 721 is narrowed as being separated from the first resin portion 6 in the width direction cross section of the first conductor wire 721.

The conductor portion side surface 724 includes a side surface flat portion 7243 in the width direction cross section of the first conductor wire 721. The side surface flat portion 7243 is a straight portion provided in the conductor portion side surface 724 in the width direction cross section of the first conductor wire 721. The side surface flat portion 7243 has flatness equal to or smaller than 0.5 $\mu$m. The conductor portion side surface 724 of this embodiment is a surface extending on a virtual straight line (not illustrated) passing through both ends 7241 and 7242 thereof. In this case, the substantially entire conductor portion side surface 724 serves as the side surface flat portion 7243.

The shape of the conductor portion side surface 724 is not particularly limited to those described above. For example, the conductor portion side surface 724 may have an arc shape protruding outward in the width direction cross section of the first conductor wire 721. In this case, the conductor portion side surface 724 exists outward of the virtual straight line passing through both ends 7241 and 7242 of the conductor portion side surface 724. In this manner, the conductor portion side surface 724 is preferably shaped not to exist inward of the virtual straight line passing through its both ends in the width direction cross section of the conductor portion. For example, it is preferable that the shape of the conductor portion side surface does not have an arc shape concave toward the inside of the conductor portion side surface (that is, the shape in which the conductor wire is flared) when the conductor wire is gradually widened as being close to the first resin portion in the width direction cross section of the conductor wire.

In order to suppress scattering of light in the conductor portion side surface 724, an angle $\theta$ of the corner between the conductor portion side surface 724 and the conductor portion top surface 723 is preferably 90° to 170° (90° $\leq \theta \leq$ 170°), and more preferably 90° to 120° (90° $\leq \theta \leq$ 120°). In this embodiment, in one first conductor wire 721, an angle between one of the conductor portion side surfaces 724 and the conductor portion top surface 723 is substantially equal to an angle between the other conductor portion side surfaces 724 and the conductor portion top surface 723.

In order to firmly fixing the first conductor portion 7 and the first resin portion 6, it is preferable that the surface roughness of the conductor portion contact surface 722 is relatively larger than the surface roughness of the conductor portion top surface 723. In this embodiment, since the conductor portion top surface 723 includes the top surface flat portion 7231, the above-described first surface roughness relative relationship is established (relationship in which the surface roughness of the conductor portion top surface 723 is relatively larger than the surface roughness of the conductor portion contact surface 722). Specifically, it is preferable that the surface roughness Ra of the conductor portion contact surface 722 is 0.1 $\mu$m to 3 $\mu$m, whereas the surface roughness of the conductor portion top surface 723 is 0.001 $\mu$m to 1.0 $\mu$m. Furthermore, it is more preferable that the surface roughness Ra of the conductor portion contact surface 722 is 0.1 $\mu$m to 0.5 $\mu$m, and it is more preferable that the surface roughness Ra of the conductor portion top surface 723 is 0.001 $\mu$m to 0.3 $\mu$m. A relationship of the surface roughness of the conductor portion top surface 723 with respect to the surface roughness of the conductor portion contact surface 722 is preferably greater than or equal to 0.01 and less than 1, and is more preferably greater than or equal to 0.1 and less than 1. The surface roughness of the conductor portion top surface 723 is preferably equal to or smaller than 1/5 of the width (maximum width) of the first conductor wire 721. Such surface roughness can be measured according to the JIS standard (JIS B0601, revised on March 21, 2013). The surface roughness of the conductor portion contact surface 722 and the surface roughness of the conductor portion top surface 723 may be measured along the width direction of the first conductor wire 721 or may be measured along the extending direction of the first conductor wire 721.

As described in the JIS standard (JIS B0601, revised on March 21, 2013), the "surface roughness Ra" indicates "arithmetical average roughness Ra." The "arithmetical average roughness Ra" indicates a roughness parameter which is obtained by blocking a long wavelength component (wave component) from the cross-sectional curve. The wave component is separated from the cross-sectional curve on the basis of a measurement condition necessary to obtain a shape (for example, a dimension or the like of the target).

In this embodiment, the conductor portion side surface 724 also includes the side surface flat portion 7243. For this reason, similar to the conductor portion top surface 723, the surface roughness of the conductor portion contact surface 722 is relatively larger than the surface roughness of the conductor portion side surface 724. The surface roughness Ra of the conductor portion side surface 724 is preferably 0.001 $\mu$m to 1.0 $\mu$m, and more preferably 0.001 $\mu$m to 0.3 $\mu$m while the surface roughness Ra of the conductor portion contact surface 722 is 0.1 $\mu$m to 3 $\mu$m. The measurement of the surface roughness of the conductor portion side surface 724 may be performed along the width direction of the first conductor wire 721 or may be performed along the extending direction of the first conductor wire 721.

When a relative relationship of the surface roughness between the conductor portion contact surface 722 and the other surface excluding the conductor portion contact surface 722 (the conductor portion top surface 723 and the conductor portion side surface 724) satisfies the aforementioned relationship, the irregular reflectance on the other surface side excluding the conductor portion contact surface 722 are smaller than the irregular reflectance on the conductor portion contact surface 722 side. In this case, a ratio between the irregular reflectance on the conductor portion contact surface 722 side and the irregular reflectance on the other surface side excluding the conductor portion contact surface 722 is preferably greater than or equal to 0.1 and less than 1, and is more preferably greater than or equal to 0.3 and less than 1.

An example of the configuration of the first conductor portion having an above-described relative relationship between the first conductor portion contact surface and the other surface excluding the first conductor portion contact surface will be described with reference to Fig. 9. In the conductor portion contact surface 722B of the first conductor portion 7B formed of the conductive particles M and the binder resin B, a part of the conductive particles M protrude from the binder resin B in the width direction cross section of the first conductor portion 7B. As a result, the conductor portion contact surface 722B has an uneven shape. Meanwhile, in the conductor portion top surface 723B and the conductor portion side surface 724B of the first conductor portion 7B, the binder resin B enters between the conductive particles M in the width direction cross section of the first conductor portion 7B. Although some slightly exposed portions of the conductive particles M are scattered on the conductor portion top surface 723B and the conductor portion side surface 724B, the binder resin B covers the conductive particles M. As a result, the straight top surface flat portion 7231B is included in the conductor portion top surface 723B, and the straight side surface flat portion 7243B is included in the conductor portion side surface 724B. In this case, the surface roughness of the conductor portion contact surface 722B is relatively larger than the surface roughness of the conductor portion top surface 723B and is also relatively larger than the surface roughness of the conductor portion side surface 724B. Since the binder resin B covers the conductive particles M in the conductor portion side surface 724B, an electric insulation property between the neighboring first conductor portions 7B is improved so that generation of migration is suppressed.

The third conductor wire 711 of the first electrode 71 has the same structure as that of the first conductor wire 721 described above. Therefore, herein, the third conductor wire 711 will not be described repeatedly by referring the description of the first conductor wire 721. The second conductor wire 731 of the first terminal 73 has the same basic configuration as that of the first conductor wire 721. Therefore, herein, the second conductor wire 731 will not be described repeatedly by referring the description of the first conductor wire 721. The conductor wires of in the first and second boundary portions 74 and 75 have the same basic configurations as that of the first conductor wire 721 described above. Therefore, herein, the conductor wires of the first and second boundary portions 74 and 75 will not be described repeatedly by referring the description of the first conductor wire 721.

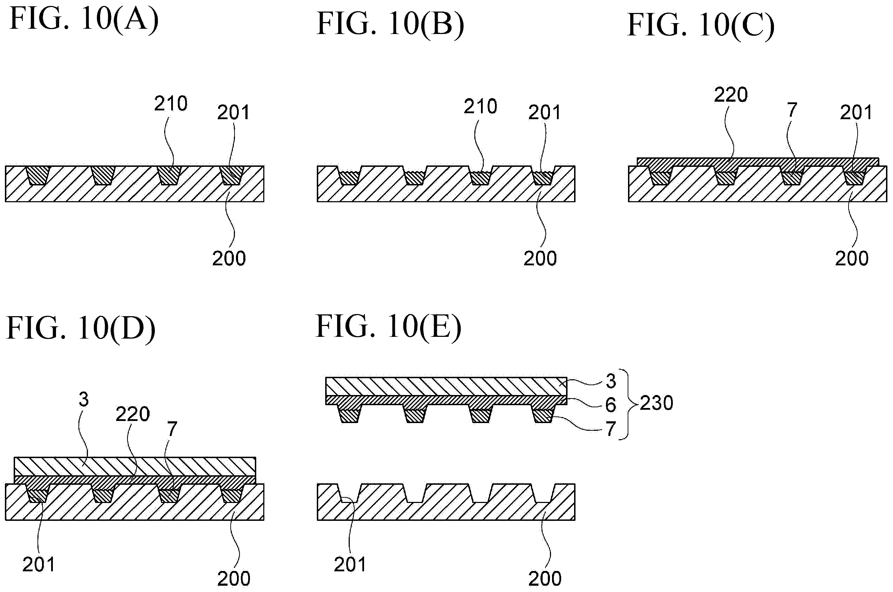

Next, a method of manufacturing the wiring board 2 in this embodiment will be described. Figs. 10(A) to 10(E), 11(A) to 11(E), 12, and 13 are cross-sectional views for illustrating the method of manufacturing the wiring board in an embodiment of the invention.

First, as illustrated in Fig. 10(A), a first conductive material 210 is filled in a first intaglio 200 on which a first concave portion 201 having a shape corresponding to the first conductor portion 7 is formed. The conductive paste described above is used as the first conductive material 210 filled in the first concave portion 201 of the first intaglio 200. As the material of which the first intaglio 200 is made, silicon, nickel, glass such as silicon dioxide, ceramics, organic silica-based materials, glassy carbon, thermoplastic resin, photocurable resin and the like can be exemplified. In order to improve mold releasability, a release layer (not illustrated) formed of a graphite-based material, a silicon-based material, a fluorine-based material, a ceramic-based material, an aluminum-based material or the like is preferably formed on the surface of the first concave portion 201 in advance.

As a method of filling the first conductive material 210 in the first concave portion 201 of the first intaglio 200, for example, a dispensing method, an inkjet method and a screen printing method can be employed. Alternatively, a method of wiping, scraping, sucking, sticking, rinsing, or blowing the first conductive material 210 which is applied to a portion other than the first concave portion 201 after performing coating by a slit coating method, a bar coating method, a blade coating method, a dip coating method, a spray coating method or a spin coating method can be exemplified. The filling method can be suitably used according to the composition of the first conductive material 210, the shape of the first intaglio 200 and the like.

Next, as illustrated in Fig. 10(B), the first conductive material 210 filled in the first concave portion 201 is heated and cured. The condition for heating the first conductive material 210 may be suitably set depending on the composition of the first conductive material 210 or the like.

The volume of the first conductive material 210 shrinks with the heating. In this case, the shape of the inner wall surface of the first concave portion 201 is transferred to a portion of the first conductive material 210 adjoining the inner wall surface of the first concave portion 201, which has a flat shape. Meanwhile, a portion of the first conductive material 210 that does not adjoin the inner wall surface of the first concave portion 201 is not affected by the shape of the inner wall surface of the first concave portion 201. For this reason, a minute uneven shape is formed in a portion of the first conductive material that does not adjoin the inner wall surface of the first concave portion 201. As a result, the first conductor portion 7 is formed.

The treatment method of the first conductive material 210 is not particularly limited to heating. Energy rays such as infrared rays, ultraviolet rays and laser light may be irradiated, or only drying may be performed. Two or more types of treatment methods may be combined.

Then, as illustrated in Fig. 10(C), a first resin material 220 for forming the first resin portion 6 is coated on the first intaglio 200. The material described above of the first resin portion 6 is used as the first resin material 220. As a method of coating the first resin material 220 on the first intaglio 200, a screen printing method, a spray coating method, a bar coating method, a dipping method and an inkjet method can be exemplified. Through this coating, the first resin material 220 enters the gap generated in the first concave portion 201 by volumetric shrinkage of the first conductive material 210 described above.

Then, as illustrated in Fig. 10(D), the support body 3 is placed on the first intaglio 200, and the support body 3 is pressed toward the first intaglio 200 while the first resin material 220 is interposed between the support body 3 and the first intaglio 200. In addition, the first resin material 220 is cured. As a method of curing the first resin material 220, irradiation of energy rays such as ultraviolet rays, infrared rays and laser light, heating, heating and cooling, drying and the like can be exemplified. As a result, the first resin portion 6 is formed.

The method of forming the first resin portion 6 is not particularly limited to those described above. For example, the first resin portion 6 may be formed by preparing the support body 3 on which the first resin material 220 is substantially uniformly coated, pressing the support body 3 to the first intaglio 200 so that the first resin material 220 enters the first concave portion 201 of the first intaglio 200, and curing the first resin material 220 while the pressing state is kept.

Then, as illustrated in Fig. 10(E), an intermediate body 230 including the support body 3, the first conductor portion 7 and the first resin portion 6 is integrally released from the first intaglio 200.

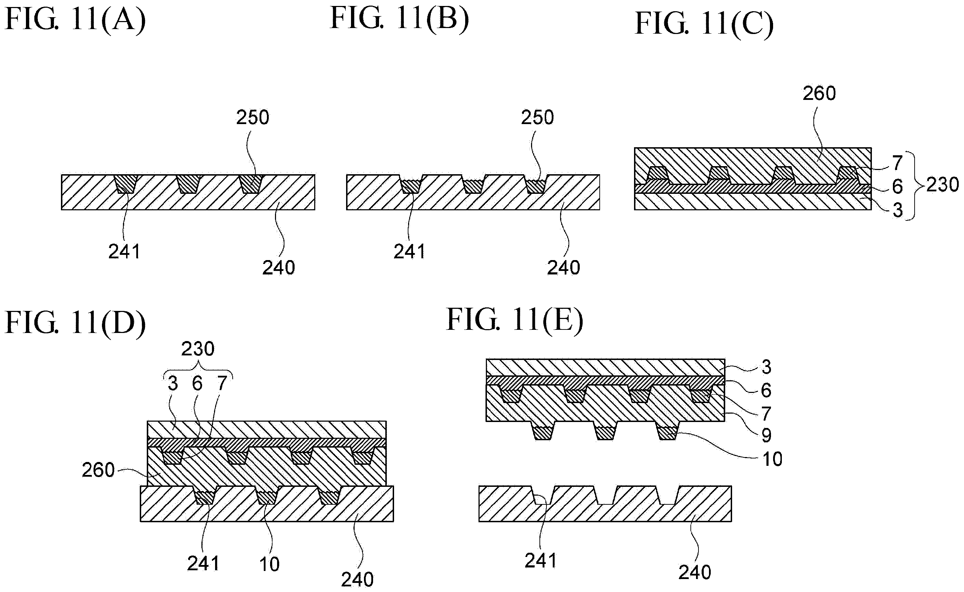

Then, as illustrated in Fig. 11(A), a second intaglio 240 on which a second concave portion 241 having a shape corresponding to the second conductor portion 10 is formed is prepared. As a material of the second intaglio 240, the same material as that of the first intaglio 200 is used. Similar to the first intaglio 200, a release layer (not illustrated) may be formed on the surface of the second intaglio 240 in advance.

Then, as illustrated in Fig. 11(B), a second conductive material 250 for forming the second conductor portion 10 is filled in the second concave portion 241 of the second intaglio 240, and the second conductive material 250 is cured. As the second conductive material 250, the conductive paste described above is used. As a method of filling the second conductive material 250 in the second concave portion 241, the same method as that used to fill the first conductive material 210 in the first concave portion 201 is used. As a method of curing the second conductive material 250, the same method as that used to cure the first conductive material 210 is used.

Then, as illustrated in Fig. 11(C), a second resin material 260 for forming the second resin portion 9 is coated on the intermediate body 230 to cover the first conductor portion 7. As the second resin material 260, the material of the second resin portion 9 is used. In order to ensuring sufficient fluidity at the time of coating, it is preferable that a viscosity of the second resin material 260 is 1 mPa·s to 10,000 mPa·s. It is preferable that a storage elastic modulus of the resin after being cured is equal to or higher than $10^6$ Pa and equal to or lower than $10^9$ Pa in terms of durability of the first or second conductor portion 7 or 10. As a method of coating the second resin material 260, the same method as that used to coat the first resin material 220 is used.

Then, as illustrated in Fig. 11(D), the intermediate body 230 is placed on the second intaglio 240, the intermediate body 230 is pressed to the second intaglio 240 so that the second resin material 260 enters the second concave portion 241 of the second intaglio 240 (specifically, a gap generated by volumetric shrinkage of the second conductive material 250), and the second resin material 260 is cured. A pressing force for pressing the intermediate body 230 to the second intaglio 240 is preferably 0.001 to 100 MPa, and more preferably, 0.01 to 10 MPa. This pressing may be performed using a pressing roller or the like. As a method of curing the second resin material 260, the same method as that used to cure the first resin material 220 is used. As a result, the second resin portion 9 is formed, and the intermediate body 230 and the second conductor portion 10 are bonded and fixed to each other via the second resin portion 9.

Then, as illustrated in Fig. 11(E), the intermediate body 230, the second resin portion 9 and the second conductor portion 10 are integrally released from the second intaglio 240.

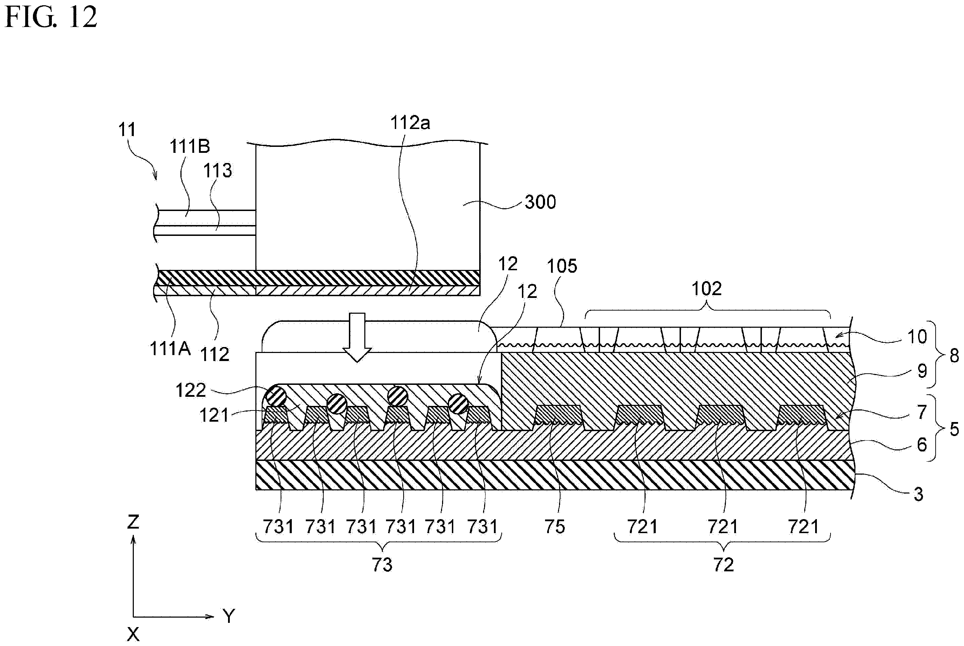

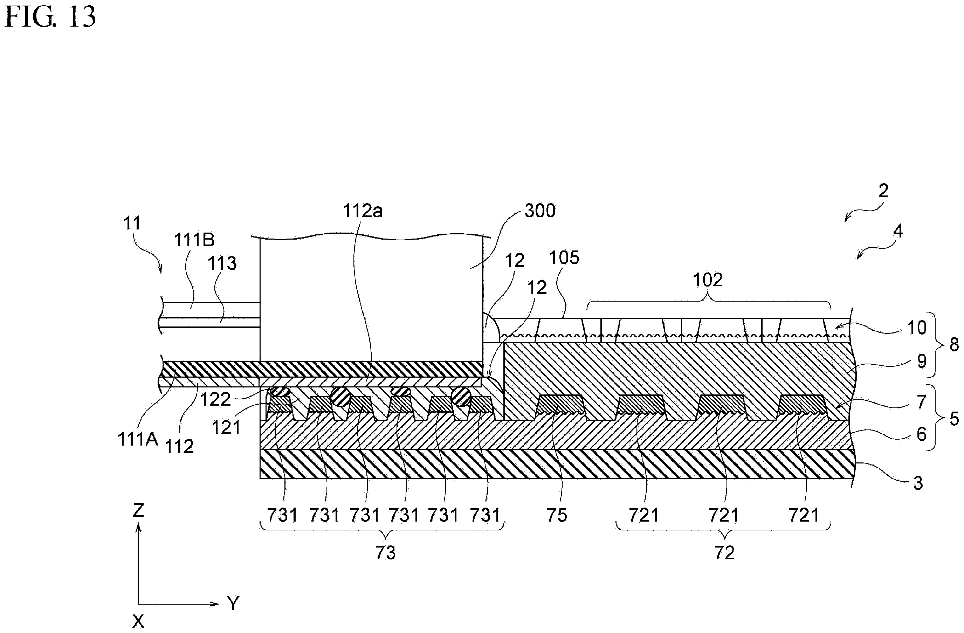

Then, as illustrated in Fig. 12, the connection terminal 112a of the wire 112 of the connection wiring body 11 prepared in advance and the first terminal 73 of the first wiring body 5 are arranged to face each other via the conductive bonding portion 12. In addition, the connection terminal 113a of the wire 113 and the second terminal 103 of the second wiring body 8 are arranged to face each other via the conductive bonding portion 12. Then, as illustrated in Fig. 13, the first and second wiring bodies 5 and 8 and the connection wiring body 11 are thermo-compression bonded via the conductive bonding portion 12 by using a thermo-compression bonding apparatus 300. As a result, the first and second wiring bodies 5 and 8 and the connection wiring body 11 are connected to each other. Through the aforementioned process, it is possible to obtain the wiring board 2.

The first wiring body 5, the wiring body assembly 4, the wiring board 2 and the touch sensor 1 in the present embodiment have the following effects.

In this embodiment, the first mesh 725 of the first lead wire 72 and the second mesh 735 of the first terminal 73 are set such that a relationship between the diameter $S_1$ and the diameter $S_2$ satisfies the aforementioned Expression (14). For this reason, the gap of the first mesh 725 of the first lead wire 72 is larger than the gap of the second mesh 735 of the first terminal 73. As a result, since the flexibility of the first lead wire 72 to expansion is improved, it is possible to prevent disconnection of the first lead wire 72. In addition, since the second mesh 735 is densely formed, it is possible to improve adherence between the first terminal 73 and the connection terminal 112a by virtue of an anchor effect of the first terminal 73. As a result, it is possible to improve connection reliability between the first wiring body 5 and the connection wiring body 11.

In this embodiment, a relationship between the widths $W_1$ and $W_2$ satisfies the aforementioned Expression (15). In this case, it is possible to set a relatively large surface area of the first terminal 73 by continually arranging the second conductor wire 731 having a relatively small width. In addition, since minute unevennesses are formed by the second conductor wire 731 in the first terminal 73, it is possible to more increase the anchor effect. As a result, since a bonding strength of the first terminal 73 with the connection wiring body 11 increases, it is possible to improve adherence between the first wiring body 5 and the connection wiring body 11. Consequently, it is possible to improve connection reliability between the first wiring body 5 and the connection wiring body 11.

In this embodiment, the relationship between the widths $W_1$ and $W_2$ satisfies the aforementioned Expression (15), and the first conductor wire 721 having a relatively large width is used in the first lead wire 72. Therefore, it is possible to reduce an electric resistance value of the first lead wire 72. As a result, it is possible to improve detection sensitivity of the touch sensor 1 using the first wiring body 5.

In this embodiment, the ratio $W_1/S_1$ between the width $W_1$ and the diameter $S_1$ and the ratio $W_2/S_2$ between

the width $W_2$ and the diameter $S_2$ have a relationship satisfying the aforementioned Expression (17). In this case, since a ratio of the area of the first lead wire 72 occupied by the conductor wire is larger than the ratio of the area of the first terminal 73 occupied by the conductor wire in the plan view, it is possible to reduce an electric resistance value of the first lead wire 72. As a result, it is possible to improve detection sensitivity of the touch sensor 1 using the first wiring body 5. Since a relationship between the ratios $A_1$ and $A_2$ satisfies the aforementioned Expression (19), it is possible to further improve detection sensitivity of the touch sensor 1 using the first wiring body 5 by more reducing the electric resistance value of the first lead wire 72.

In this embodiment, the relationship between the diameters $S_1$ and $S_3$ satisfies the aforementioned Expression (13). In this case, since the light easily passes through a gap between the third conductor wire 711 in the first electrode 71, it is possible to improve visibility of the touch sensor 1 using the first wiring body 5.

In this embodiment, the relationship between the widths $W_2$ and $W_3$ satisfies the aforementioned Expression (16). In this case, it is difficult to visually recognize the third conductor wire 711 of the first electrode 71, and it is difficult to block light by the third conductor wire 711 in the first electrode. Therefore, it is possible to improve visibility of the touch sensor 1 using the first wiring body 5.

In this embodiment, the ratio $W_2/S_2$ between of the width $W_2$ and the diameter $S_2$ and the ratio $W_3/S_3$ between the width $W_3$ and the diameter $S_3$ have a relationship satisfying the aforementioned Expression (18). Therefore, it is possible to reduce the ratio of the area of the first electrode 71 occupied by the conductor wire. As a result, light can easily transmit in the first electrode 71, and it is possible to improve visibility of the touch sensor 1 using the first wiring body 5. Since the relationship between the ratios $A_2$ and $A_3$ satisfies the aforementioned Expression (20), it is difficult to block light by the third conductor wire 711 in the first electrode 71. Therefore, it is possible to further improve visibility of the touch sensor 1 using the first wiring body 5.

In this embodiment, the second boundary portion 75 is interposed between the first lead wire 72 and the first terminal 73 to electrically connect the first lead wire 72 and the first terminal 73. For this reason, even when the mesh shape of the first lead wire 72 is different from the mesh shape of the first terminal 73, it is possible to more reliably electrically connect the first lead wire 72 and the first terminal 73.

In this embodiment, the first terminal 73 of the first wiring body 5 and the connection terminal 112a of the connection wiring body 11 are bonded to each other with the conductive bonding portion 12. In addition, the relationship between the diameter $S_2$ and the diameter D of the terminal conductive particle 122 contained in the conductive bonding portion 12 satisfies the aforementioned Expression (10). In this case, it is possible to suppress the terminal conductive particle 122 from falling into the second mesh 735, and it is possible to more reliably electrically connect the first terminal 73 and the connection terminal 112a via the terminal conductive particle 122. As a result, it is possible to improve connection reliability between the first wiring body 5 and the connection wiring body 11. Furthermore, it is possible to reduce a contact resistance between the first terminal 73 and the connection terminal 112a. Therefore, it is possible to improve detection sensitivity of the touch sensor 1 using the first wiring body 5.

In particular, since the relationship between the diameters D and $S_2$ satisfies the aforementioned Expression (11), the terminal conductive particle 122 is easily caught by the second mesh 735 of the first terminal 73 when the first wiring body 5 and the connection wiring body 11 are thermo-compression bonded. Therefore, it is possible to suppress the terminal conductive particles 122 from flowing out through the gap between the first wiring body 5 and the connection wiring body 11. As a result, it is possible to more reliably electrically connect the first terminal 73 and the connection terminal 112a, and it is possible to improve connection reliability between the first wiring body 5 and the connection wiring body 11.

According to this embodiment, the second conductor wire 731 has a tapered shape in which the second conductor wire 731 is narrowed as being separated from the first resin portion 6 in the width direction cross section of the second conductor wire 731. For this reason, the terminal conductive particle 122 is more easily caught by the second mesh 735 of the first terminal 73 when the first wiring body 5 and the connection wiring body 11 are thermo-compression bonded, and it is possible to suppress the terminal conductive particles 122 from flowing out through the gap between the first wiring body 5 and the connection wiring body 11. As a result, it is possible to more reliably electrically connect the first terminal 73 and the connection terminal 112a, and it is possible to improve connection reliability between the first wiring body 5 and the connection wiring body 11.

In this embodiment, the basic structure of the second wiring body 8 is similar to that of the first wiring body 5. For this reason, it is possible to obtain the same functional effects as those described above even in a connection structure between the second wiring body 8 and the connection wiring body 11.

Table 1 shows a relationship between a ratio $S_1/S_2$ between the diameter $S_1$ ($\mu$m) of the first virtual circle 726 of the first lead wire 72 and the diameter $S_2$ ($\mu$m) of the second virtual circle 736 of the first terminal 73, evaluation of an expansion ratio (%) when the resistance of the first lead wire 72 is 1.5 times, and a compression ratio (%) of the terminal conductive particle 122 having a diameter of 10 $\mu$m. The diameter $S_1$ ($\mu$m) of the first virtual circle 726 and the diameter $S_2$ ($\mu$m) of the second virtual circle 736 are adjusted within a range of 5 to 15 $\mu$m.

[Table 1]

| $S_1/S_2$ | Expansion ratio (%) of first lead wire | Compression ratio (%) of terminal conductive particle |
|---|---|---|
| 1 | B | A |
| 1.5 | A | A |
| 2 | A | A |
| 3 | A | A |
| 0.5 | B | B |
| - (Solid printing) | C | B |

The aforementioned expansion ratio is an expansion ratio of the first lead wire 72 at the time that the resistance value of the first lead wire 72 increases to 1.5 times by applying a tension to the first lead wire 72. Here, it is assumed that a break occurs in the first lead wire 72 when the resistance value increases to 1.5 times. The compression ratio of the terminal conductive particle 122 is a ratio of the minimum diameter after use with respect to the diameter before use. The expansion ratio of the first lead wire 72 was evaluated in three grades including "EXCELLENT ("A" in the table)," "GOOD ("B" in the table)," and "UNALLOWABLE ("C" in the table)." The compression ratio of the terminal conductive particle 122 was evaluated in two grades including "GOOD ("A" in the table)" and "UNALLOWABLE ("B" in the table)." When the expansion ratio of the first lead wire 72 is equal to or higher than 10%, the flexibility of the first lead wire 72 to the expansion is evaluated as "EXCELLENT." When the expansion ratio of the first lead wire 72 is 5% to 10%, the flexibility of the first lead wire 72 to expansion is evaluated as "GOOD." When the expansion ratio of the first lead wire 72 is lower than 5%, the flexibility of the first lead wire 72 to expansion is evaluated as "UNALLOWABLE." When the compression ratio of the terminal conductive particle 122 is equal to or higher than 80%, the connection reliability of the first terminal 73 was evaluated as "GOOD." When the compression ratio of the terminal conductive particle 122 is lower than 80% or when it is difficult to connect the first terminal 73 and the connection terminal 112a, the connection reliability of the first terminal 73 was evaluated as "UNALLOWABLE."

As illustrated in Table 1, when the ratio $S_1/S_2$ between the diameter $S_1$ of the first virtual circle 726 of the first lead wire 72 and the diameter $S_2$ of the second virtual circle 736 of the first terminal 73 is set to 1, the flexibility of the first lead wire 72 to expansion was evaluated as "GOOD," and the connection reliability of the first terminal 73 was evaluated as "GOOD."

As illustrated in Table 1, when the ratio $S_1/S_2$ between the diameter $S_1$ of the first virtual circle 726 of the first lead wire 72 and the diameter $S_2$ of the second virtual circle 736 of the first terminal 73 is set to 1.5, the flexibility of the first lead wire 72 to expansion was evaluated as "EXCELLENT," and the connection reliability of the first terminal 73 was evaluated as "GOOD."

As illustrated in Table 1, when the ratio $S_1/S_2$ between the diameter $S_1$ of the first virtual circle 726 of the first lead wire 72 and the diameter $S_2$ of the second virtual circle 736 of the first terminal 73 is set to 2, the flexibility of the first lead wire 72 to expansion was evaluated as "EXCELLENT," and the connection reliability of the first terminal 73 was evaluated as "GOOD."

As illustrated in Table 1, when the ratio $S_1/S_2$ between the diameter $S_1$ of the first virtual circle 726 of the first lead wire 72 and the diameter $S_2$ of the second virtual circle 736 of the first terminal 73 is set to 3, the flexibility of the first lead wire 72 to expansion was evaluated as "EXCELLENT," and the connection reliability of the first terminal 73 was evaluated as "GOOD."

As illustrated in Table 1, when the ratio $S_1/S_2$ between the diameter $S_1$ of the first virtual circle 726 of the first lead wire 72 and the diameter $S_2$ of the second virtual circle 736 of the first terminal 73 is set to 0.5, the flexibility of the first lead wire 72 to expansion was evaluated as "GOOD" and the connection reliability of the first terminal 73 was evaluated as "UNALLOWABLE."

As illustrated in Table 1, when the first lead wire 72 is formed through solid printing, the flexibility of the first lead wire 72 to expansion was evaluated as "UNALLOWABLE." In addition, when the first terminal 73 is formed through solid printing, the connection reliability of the first terminal 73 was evaluated as "UNALLOWABLE."

From the aforementioned results, it was recognized that the ratio $S_1/S_2$ between the diameter $S_1$ of the first virtual circle 726 of the first lead wire 72 and the diameter $S_2$ of the second virtual circle 736 of the first terminal 73 is preferably equal to or greater than 1 and more preferably be equal to or greater than 1.5. An upper limit of the ratio $S_1/S_2$ between the diameter $S_1$ of the first virtual circle 726 of the first lead wire 72 and the diameter $S_2$ of the second virtual circle 736 of the first terminal 73 may be equal to or lower than 3, but not particularly limited thereto.

Embodiments heretofore explained are described to facilitate understanding of the present invention and are not described to limit the present invention. It is therefore intended that the elements disclosed in the above embodiments include all design changes and equivalents to fall within the technical scope of the present invention.

For example, the touch sensor of this embodiment is a projection electrostatic capacitance type touch panel sensor including a wiring board including a pair of wiring bodies, but is not particularly limited thereto, and it is also possible to apply the present invention to a surface (capacitive coupling) electrostatic capacitance type touch panel sensor including a single wiring body.

For example, in this embodiment, a metal material or a carbon-based material is used as a conductive material (conductive particle) included in the first and second conductor portions 7 and 10. However, a conductive material is not particularly limited thereto, a combination of the metal material and the carbon-based material may be used. For example, in the case of the first conductor wire 721, the carbon-based material may be disposed on the conductor portion top surface 723 side of the first conductor portion 7, and the metal material may be disposed on the conductor portion contact surface 722 side. Reversely, the metal material may be disposed on the conductor portion top surface 723 side of the first conductor portion 7, and the carbon-based material may be disposed on the conductor portion contact surface 722 side.

Although not illustrated in particular, the support body 3 may be omitted from the wiring board 2 in the aforementioned embodiment. In this case, for example, a wiring body may be configured such that a release sheet is provided on a lower surface of the first resin portion 6, the release sheet is peeled off at the time of mounting the wiring body, and the wiring body is mounted on a mounting target (a film, surface glass, a polarizing plate, display glass or the like) by adhering thereto. A wiring body may be configured such that a resin portion is further provided to cover the wiring board 2 (first wiring body 5) from the first resin portion 6 side, and the wiring body is mounted on the mounting target described above by adhering thereto via the resin portion. A wiring body may be configured such that a resin portion is provided to cover the second wiring body 8 from the second conductor portion 10 side, the wiring body is mounted on the mounting target described above by adhering thereto via the resin portion. In these case, the mounting target on which the wiring body is mounted corresponds to an example of the support body in the present invention.

Further, in the embodiment described above, the wiring body or the wiring board has been described as being used in the touch sensor, but is not particularly limited thereto. For example, the wiring body may be used as a heater by energizing the wiring body to generate heat according to resistance heating or the like. In this case, it is preferable that a carbon-based material having a high comparatively electrical resistance value is used as the conductive particles of the conductor portion. A part of the conductor portion of the wiring body is grounded, and thus, the wiring body may be used as an electromagnetic shielding shield. The wiring body may be used as an antenna. In these case, the mounting target on which the wiring body is mounted corresponds to an example of the support body in the present invention.

EXPLANATIONS OF LETTERS OR NUMERALS

| 1 | touch sensor |
|---|---|
| 2 | wiring board |
| 3 | support body |
| 4 | wiring body assembly |
| 5 | first wiring body |
| 6 | first resin portion |
| 61 | flat portion |
| 62 | protruding portion |
| 621 | resin portion contact surface |
| 7 | first conductor portion |
| 71 | first electrode |
| 711 | third conductor wire |
| 715 | third mesh |
| 716 | third virtual circle |
| 72 | first lead wire |
| 721 | first conductor wire |
| 722 | conductor portion contact surface |
| 723 | conductor portion top surface |
| 7231 | top surface flat portion |
| 724 | conductor portion side surface |
| 7241, 7242 | end |
| 7243 | side surface flat portion |

| 725 | first mesh |
| 726 | first virtual circle |
| 73 | first terminal |
| 731 | second conductor wire |
| 735 | second mesh |
| 736 | second virtual circle |
| 74 | first boundary portion |
| 75 | second boundary portion |
| 8 | second wiring body |
| 9 | second resin portion |
| 10 | second conductor portion |
| 101 | second electrode |
| 102 | second lead wire |
| 103 | second terminal |
| 104 | third boundary portion |
| 105 | fourth boundary portion |
| 11 | connection wiring body |
| 111 | substrate |
| 111A | first branch |
| 111B | second branch |
| 111C | slit |
| 112 | wire |
| 112a | connection terminal |
| 113 | wire |
| 113a | connection terminal |
| 12 | conductive bonding portion |
| 121 | resin material |
| 122 | terminal conductive particle |
| 200 | first intaglio |
| 201 | first concave portion |
| 210 | first conductive material |
| 220 | first resin material |
| 230 | intermediate body |
| 240 | second intaglio |
| 241 | second concave portion |
| 250 | second conductive material |
| 260 | second resin material |
| 300 | thermo-compression bonding apparatus |

**Claims**

1. A wiring body comprising:

   a resin portion; and
   a conductor portion provided on the resin portion, wherein
   the conductor portion includes
   a lead wire which has a mesh shape including first conductor wires, and
   a first terminal which is electrically connected to the lead wire and has a mesh shape including second conductor wires,
   the first conductor wires intersect with each other to form first meshes in a plan view,
   the second conductor wires intersect with each other to form second meshes in a plan view, and
   a following Expression (1) is satisfied:

$$S_2 \leq S_1 \ldots (1)$$

where, in the Expression (1),

S$_1$ denotes a diameter of a first virtual circle inscribed in the first mesh, and

S$_2$ denotes a diameter of a second virtual circle inscribed in the second mesh.

2. The wiring body according to claim 1, wherein
a following Expression (2) is satisfied:

$$W_2 \leq W_1 \ \dots \ (2)$$

where, in the Expression (2),

W$_1$ denotes a width of the first conductor wire,

W$_2$ denotes a width of the second conductor wire, and

the case where S$_1$ = S$_2$ and W$_1$ = W$_2$ is excluded.

3. The wiring body according to claim 2, wherein
a following Expression (3) is satisfied:

$$W_2/S_2 \leq W_1/S_1 \ \dots \ (3).$$

4. The wiring body according to any one of claims 1 to 3, wherein
a following Expression (4) is satisfied:

$$A_2 \leq A_1 \ \dots \ (4)$$

where, in the Expression (4),

A$_1$ denotes a ratio of an area of the lead wire occupied by the first conductor wire, and

A$_2$ denotes a ratio of an area of the first terminal occupied by the second conductor wire.

5. The wiring body according to any one of claims 1 to 4, wherein
the conductor portion further includes an electrode which is electrically connected to the lead wire and has a mesh shape including third conductor wires,
the third conductor wires intersect with each other to form third meshes in a plan view, and
a following Expression (5) is satisfied:

$$S_1 < S_3 \ \dots \ (5)$$

where, in the Expression (5), S$_3$ denotes a diameter of a third virtual circle inscribed in the third mesh.

6. The wiring body according to claim 5, wherein
a following Expression (6) is satisfied:

$$W_3 < W_2 \ \dots \ (6)$$

where, in the Expression (6), W$_3$ denotes a width of the third conductor wire.

7. The wiring body according to claim 6, wherein
a following Expression (7) is satisfied:

$$W_3/S_3 < W_2/S_2 \ \dots \ (7).$$

8. The wiring body according to any one of claims 5 to 7, wherein
   a following Expression (8) is satisfied:

$$A_3 < A_2 \ldots (8),$$

where, in the Expression (8), $A_3$ denotes a ratio of an area of the electrode occupied by the third conductor wire.

9. The wiring body according to any one of claims 1 to 8, wherein
   the conductor portion further includes a boundary portion which is interposed between the lead wire and the first terminal and electrically connects the lead wire and the first terminal.

10. A wiring body assembly comprising:

    the wiring body according to any one of claims 1 to 9;
    a connection wiring body which includes a substrate and a second terminal provided on the substrate to face the first terminal; and
    a conductive bonding portion provided between the first and second terminals to bond the first and second terminals.

11. The wiring body assembly according to claim 10, wherein
    the conductive bonding portion includes a resin material and a terminal conductive particle dispersed in the resin material, and
    a following Expression (9) is satisfied:

$$S_2 < D \ldots (9),$$

where, in the Expression (9), D denotes a diameter of the terminal conductive particle.

12. A wiring board comprising:

    a wiring body according to any one of claims 1 to 9 or a wiring body assembly according to claim 10 or 11; and
    a support body which supports the wiring body or the wiring body assembly.

13. A touch sensor comprising the wiring board according to claim 12.

# FIG. 1

# FIG. 2

FIG. 3

# FIG. 4

# FIG. 5

EP 3 451 132 A1

FIG. 6

# FIG. 7

FIG. 8

FIG. 9

FIG. 10(A)

FIG. 10(B)

FIG. 10(C)

FIG. 10(D)

FIG. 10(E)

EP 3 451 132 A1

FIG. 11(A)

FIG. 11(B)

FIG. 11(C)

250

250

260

241

240

241

240

7
6    230
3

FIG. 11(D)

FIG. 11(E)

230

3  6  7

260

241   10   240

3
6
7
9

10

241

240

EP 3 451 132 A1

EP 3 451 132 A1

FIG. 12

FIG. 13

## INTERNATIONAL SEARCH REPORT

| | International application No. |
|---|---|
| | PCT/JP2017/016351 |

**A. CLASSIFICATION OF SUBJECT MATTER**
*G06F3/041*(2006.01)i, *G06F3/044*(2006.01)i, *H05K1/02*(2006.01)i

According to International Patent Classification (IPC) or to both national classification and IPC

**B. FIELDS SEARCHED**

Minimum documentation searched (classification system followed by classification symbols)
G06F3/041, G06F3/044, H05K1/02

Documentation searched other than minimum documentation to the extent that such documents are included in the fields searched
Jitsuyo Shinan Koho          1922–1996    Jitsuyo Shinan Toroku Koho    1996–2017
Kokai Jitsuyo Shinan Koho    1971–2017    Toroku Jitsuyo Shinan Koho    1994–2017

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 3191884 U  (Shenzhen O-film Tech Co., Ltd.), 17 July 2014 (17.07.2014), paragraphs [0014] to [0034]; fig. 1 to 6 (Family: none) | 1-13 |
| Y | JP 2013-152599 A  (Fujifilm Corp.), 08 August 2013 (08.08.2013), paragraphs [0049] to [0051]; fig. 1 to 3 (Family: none) | 1-13 |

☒  Further documents are listed in the continuation of Box C.          ☐  See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 14 June 2017 (14.06.17) | 27 June 2017 (27.06.17) |

| Name and mailing address of the ISA/ | Authorized officer |
|---|---|
| Japan Patent Office 3-4-3,Kasumigaseki,Chiyoda-ku, Tokyo 100-8915,Japan | Telephone No. |

Form PCT/ISA/210 (second sheet) (January 2015)

## INTERNATIONAL SEARCH REPORT

| | International application No. |
|---|---|
| | PCT/JP2017/016351 |

**C (Continuation).   DOCUMENTS CONSIDERED TO BE RELEVANT**

| Category* | Citation of document, with indication, where appropriate, of the relevant passages | Relevant to claim No. |
|---|---|---|
| Y | JP 2013-127658 A  (Fujifilm Corp.),<br>27 June 2013 (27.06.2013),<br>paragraphs [0042] to [0053]; fig. 1 to 2<br>& US 2014/0238730 A1<br>paragraphs [0065] to [0083]; fig. 1 to 2<br>& US 2014/0231120 A1    & WO 2013/089085 A1<br>& EP 2765490 A1          & EP 2781996 A2<br>& CN 103907082 A         & CN 103984461 A<br>& KR 10-2014-0063900 A  & KR 10-2014-0090176 A<br>& TW 201327315 A         & TW 201432527 A | 1-13 |
| Y | WO 2016/002279 A1  (Fujifilm Corp.),<br>07 January 2016 (07.01.2016),<br>paragraphs [0028] to [0074]; fig. 1 to 10<br>& US 2017/0052639 A1<br>paragraphs [0044] to [0090]; fig. 1 to 10<br>& TW 201601030 A | 1-13 |
| Y | JP 2015-524961 A  (Nanchang O-Film Tech Co.,<br>Ltd.),<br>27 August 2015 (27.08.2015),<br>paragraphs [0024] to [0039]; fig. 1 to 3, 5<br>& US 2014/0353009 A1<br>paragraphs [0047] to [0053]; fig. 1 to 3, 5<br>& WO 2014/190594 A1     & CN 103294272 A<br>& KR 10-2015-0003085 A  & TW 201445391 A | 1-13 |
| A | WO 2015/174126 A1  (Fujifilm Corp.),<br>19 November 2015 (19.11.2015),<br>paragraphs [0044] to [0093]; fig. 1 to 5<br>& US 2017/0010720 A1<br>paragraphs [0060] to [0109]; fig. 1 to 5<br>& CN 106170751 A          & KR 10-2016-0130305 A | 1-13 |

Form PCT/ISA/210 (continuation of second sheet) (January 2015)

**EP 3 451 132 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016087634 A

- WO 2015008934 A